(19) **Europäisches Patentamt / European Patent Office / Office européen des brevets**

(11) **EP 4 471 356 A1**

(12) **EUROPEAN PATENT APPLICATION**
published in accordance with Art. 153(4) EPC

(43) Date of publication:
04.12.2024 Bulletin 2024/49

(21) Application number: 23746941.6

(22) Date of filing: 24.01.2023

(51) International Patent Classification (IPC):
*F25B 9/00* $^{(2006.01)}$     *C09K 5/14* $^{(2006.01)}$

(52) Cooperative Patent Classification (CPC):
C09K 5/14; F25B 9/00; Y02E 60/14

(86) International application number:
PCT/JP2023/002098

(87) International publication number:
WO 2023/145730 (03.08.2023 Gazette 2023/31)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 28.01.2022 JP 2022011474

(71) Applicants:
- **Kabushiki Kaisha Toshiba**
  **Tokyo 105-0023 (JP)**
- **Toshiba Materials Co., Ltd.**
  **Isogo-Ku**
  **Yokohama-Shi**
  **Kanagawa 235-0032 (JP)**

(72) Inventors:
- **KAWAMOTO, Takahiro**
  **Yokohama-shi Kanagawa 235-0032 (JP)**
- **USUI, Daichi**
  **Yokohama-shi, Kanagawa 235-0032 (JP)**
- **TAGUCHI, Seina**
  **Yokohama-shi Kanagawa 235-0032 (JP)**
- **HIRAMATSU, Ryosuke**
  **Yokohama-shi Kanagawa 235-0032 (JP)**
- **KONDO, Hiroyasu**
  **Yokohama-shi Kanagawa 235-0032 (JP)**

(74) Representative: **Henkel & Partner mbB**
**Patentanwaltskanzlei, Rechtsanwaltskanzlei**
**Maximiliansplatz 21**
**80333 München (DE)**

(54) **COLD STORAGE MATERIAL, COLD STORAGE MATERIAL PARTICLES, GRANULAR PARTICLES, COLD STORAGE MACHINE, REFRIGERATOR, CRYO-PUMP, SUPER-CONDUCTING MAGNET, NUCLEAR MAGNETIC RESONANCE IMAGING DEVICE, NUCLEAR MAGNETIC RESONANCE DEVICE, MAGNETIC FIELD APPLICATION-TYPE SINGLE CRYSTAL PULLING DEVICE, HELIUM RECONDENSING DEVICE, AND DILUTION REFRIGERATOR**

(57) A cold storage material according to an embodiment comprises: a rare earth oxysulfide including a rare earth element; a garnet-type rare earth oxide including a rare earth element and Al; and aluminum oxide, wherein the ratio of an X-ray diffraction peak intensity of the garnet-type rare earth oxide to an X-ray diffraction peak intensity of the rare earth oxysulfide is 0.1% to 40%.

EP 4 471 356 A1

【FIG.1】

**Description**

TECHNICAL FIELD

Embodiments of the present invention relate to a cold storage material, a cold storage material particle, a granulated particle, a cold storage device, a refrigerator, a cryopump, a superconducting magnet, a nuclear magnetic resonance imaging apparatus, a nuclear magnetic resonance apparatus, a magnetic field application type single crystal pulling apparatus, a helium re-condensing device, and a dilution refrigerator.

BACKGROUND ART

In recent years, development of superconducting technology has been remarkable, and development of a cryogenic refrigerator having high performance and high reliability has become indispensable as the application field thereof expands. Such a cryogenic refrigerator is required to exhibit high thermal efficiency for a long period of time.

In a cryogenic refrigerator, a plurality of cold storage materials are housed in a cold storage device. For example, cold is generated by heat exchange between the cold storage material and helium gas passing through the cold storage device. For example, in a superconducting MRI apparatus, a cryopump, or the like, a refrigerator using a refrigeration cycle such as a Gifford-McMahon (GM) system, a Stirling system, or a pulse tube system is used.

In addition, a high-performance refrigerator is also required for a magnetically levitated train in order to generate a magnetic force using a superconducting magnet. Furthermore, in recent years, a high-performance refrigerator has also been used in a superconducting magnetic energy storage (SMES), a magnetic field application type single crystal pulling apparatus for producing high-quality silicon wafers, and the like. Further, development and practical application of a pulse tube refrigerator, which is expected to have high reliability, are also actively promoted.

In addition, in the superconducting magnet, the MRI apparatus, and the like as described above, since the liquid helium to be used evaporates, the supply of the liquid helium becomes a problem. In recent years, the problem of depletion of helium has become serious, and a difficult state of availability has occurred, affecting the industry.

In order to reduce consumption of the liquid helium and reduce a load of maintenance such as the supply thereof, a helium re-condensing device for re-condensing evaporated helium has been put into practical use, and demand for the helium re-condensing device has increased. Also in this helium re-condensing device, a GM refrigerator or a pulse tube refrigerator is used to cool the temperature to a 4K level in order to liquefy helium.

In addition, in order to prevent evaporation at the time of liquefying a gas other than helium or storing a liquefied gas, a GM refrigerator or a pulse tube refrigerator can be used. The gas other than helium is, for example, hydrogen. Since the boiling point of liquefied hydrogen is about 20 K, evaporation of liquefied hydrogen can be reduced by keeping the temperature at 20 K or lower.

In a refrigerator equipped with a cold storage material, a working medium such as a compressed helium (He) gas flows in one direction in a cold storage device in which the cold storage material is accommodated, and thermal energy thereof is supplied to the cold storage material. Then, the expanded working medium flows in the opposite direction in the cold storage device and receives the thermal energy from the cold storage material. As a recuperating effect in such a process is improved, thermal efficiency in a working medium cycle is improved, and a lower temperature can be realized.

Here, as a specific heat per unit volume of the cold storage material mounted on the cold storage device is higher, the thermal energy that can be stored in the cold storage material increases, so that refrigeration capacity of the refrigerator is improved. Therefore, it is desirable to mount a cold storage material having high specific heat at a low temperature on a low-temperature side of the cold storage device and a cold storage material having high specific heat at a high temperature on a high-temperature side.

The cold storage material exhibits high volume specific heat in a specific temperature range depending on a composition thereof. Therefore, by combining cold storage materials having different compositions that exhibit high volume specific heat in a target temperature range, the cold storage capacity is enhanced, and the refrigeration capacity of the refrigerator is improved.

In conventional refrigerators, freezing at 4 K has been achieved by combining a metal-based cold storage material such as lead (Pb), bismuth (Bi), or tin (Sn) on the high temperature side with a metal-based magnetic cold storage material such as $Er_3Ni$, ErNi, or $HoCu_2$ on the low temperature side of 20 K or less.

In recent years, attempts have been made to improve the refrigeration capacity of a refrigerator by substituting some of metal-based magnetic cold storage material particles with ceramic magnetic cold storage material particles such as $Gd_2O_2S$, $Tb_2O_2S$, $Dy_2O_2S$, $Ho_2O_2S$, and $GdAlO_3$ having high specific heat in a temperature range of 2 K to 10 K.

In addition, when a refrigerator is applied to a superconducting device or prevention of evaporation of a liquefied gas, the refrigerator is required to exhibit high thermal efficiency for a long period of time. In a cycle in which the cold storage material and an operating substance exchange heat, mechanical vibration is applied to the cold storage material. Therefore, during the operation of the refrigerator, vibration is constantly applied to the cold storage material at the operating temperature of the refrigerator. When the amount of the cold storage material damaged by this vibration becomes a certain amount or more, the flow of the working medium such as helium (He) gas is deteriorated, and the thermal efficiency is lowered. When the cold storage material is significantly damaged, the working medium such as He gas does not flow, and the refrigerator stops.

For this reason, in order to improve the long-term reliability of the refrigerator, the cold storage material is required to be broken by a certain amount or less even when vibration is applied for a long time at a temperature at which the refrigerator operates. In particular, since the ceramic magnetic cold storage material particles have brittleness, they are required to have high strength.

CITATION LIST

PATENT LITERATURE

Patent Literature 1: JP 2003-73661 A
Patent Literature 2: JP 2003-213252 A
Patent Literature 3: WO 2018/025581 A

SUMMARY OF THE INVENTION

PROBLEM TO BE SOLVED BY THE INVENTION

An object of the present invention is to provide a cold storage material having high volume specific heat and high strength.

Patent Literature 2 and Patent Literature 3 report that strength is improved by adding a compound such as $Al_2O_3$ (alumina) to a rare earth oxysulfide cold storage material. Patent Literature 2 reports that strength is improved by reducing the size of crystal grains (grains). However, in order to further improve the reliability of the refrigerator, it is required to further improve the strength while maintaining high volume specific heat.

MEANS FOR SOLVING PROBLEM

A cold storage material of an embodiment includes a rare earth oxysulfide containing at least one rare earth element selected from the group consisting of Y, La, Ce, Pr, Nd, Sm, Eu, Gd, Tb, Dy, Ho, Er, Tm, Yb, and Lu, a garnet-type rare earth oxide containing at least one rare earth element selected from the group consisting of Y, La, Ce, Pr, Nd, Sm, Eu, Gd, Tb, Dy, Ho, Er, Tm, Yb, and Lu, and Al, and an aluminum oxide, in which a ratio of X-ray diffraction peak intensity of the garnet-type rare earth oxide to X-ray diffraction peak intensity of the rare earth oxysulfide is 0.1% or more and 40% or less.

BRIEF DESCRIPTION OF THE DRAWINGS

FIG. 1 is a schematic cross-sectional view of a cold storage material according to a first embodiment.
FIG. 2 is a schematic cross-sectional view of a cold storage material according to a modification of the first embodiment.
FIG. 3 is a schematic cross-sectional view of a cold storage material particle according to a second embodiment.
FIG. 4 is a schematic cross-sectional view of a granulated particle of a second embodiment.
FIG. 5 is a schematic cross-sectional view illustrating a configuration of a main part of a refrigerator according to a fourth embodiment.
FIG. 6 is a schematic cross-sectional view illustrating a schematic configuration of a cryopump according to a fifth embodiment.
FIG. 7 is a schematic perspective view illustrating a schematic configuration of a superconducting magnet of a sixth embodiment.
FIG. 8 is a schematic cross-sectional view illustrating a schematic configuration of a nuclear magnetic resonance imaging apparatus of a seventh embodiment.
FIG. 9 is a schematic diagram illustrating a schematic configuration of a nuclear magnetic resonance apparatus of an eighth embodiment.
FIG. 10 is a schematic perspective view illustrating a schematic configuration of a magnetic field application type single crystal pulling apparatus according to a ninth embodiment.

FIG. 11 is a schematic diagram illustrating a schematic configuration of a helium re-condensing device according to a tenth embodiment.

FIG. 12 is a schematic diagram illustrating a schematic configuration of a dilution refrigerator according to an eleventh embodiment.

EMDODIMENT(S) FOR CARRYING OUT THE INVENTION

Hereinafter, embodiments of the present invention will be described with reference to the drawings. In the following description, the same or similar members and the like are denoted by the same reference numerals, and the description of the members and the like once described may be appropriately omitted.

In the present specification, a cryogenic temperature means, for example, a temperature range in which a superconducting phenomenon can be industrially useful. For example, the temperature range is a temperature range of 20K or less.

(First Embodiment)

A cold storage material of a first embodiment includes a rare earth oxysulfide containing at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu), a garnet-type rare earth oxide containing at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu) and aluminum (Al), and an aluminum oxide. A ratio of X-ray diffraction peak intensity of the garnet-type rare earth oxide to X-ray diffraction peak intensity of the rare earth oxysulfide is 0.1% or more and 40% or less.

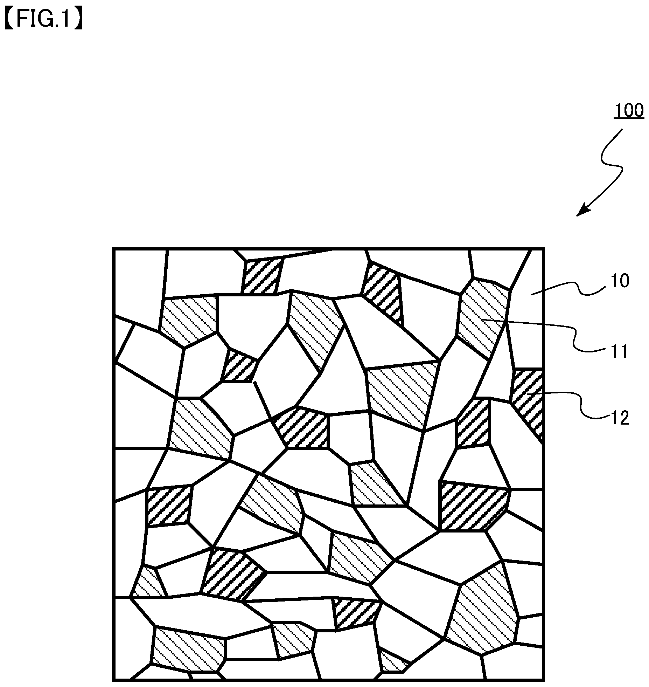

FIG. 1 is a schematic cross-sectional view of a cold storage material according to a first embodiment. A cold storage material 100 of the first embodiment is a ceramic magnetic cold storage material.

The cold storage material 100 of the first embodiment contains a rare earth oxysulfide 10, a garnet-type rare earth oxide 11, and an aluminum oxide 12. Hereinafter, the aluminum oxide may be referred to as alumina.

In the cold storage material 100 of the first embodiment, for example, a maximum value of volume specific heat in a temperature range of 2 K or more and 10 K or less is 0.5 $J/(cm^3 \cdot K)$ or more. In the cold storage material 100 of the first embodiment, for example, the volume specific heat in a temperature range of 2.5 K or more and 10 K or less is 0.5 $J/(cm^3 \cdot K)$ or more. In the cold storage material 100 of the first embodiment, for example, the volume specific heat in a temperature range of 2 K or more and 8 K or less of 0.55 $J/(cm^3 \cdot K)$ or more. In the cold storage material 100 of the first embodiment, for example, the volume specific heat in a temperature range of 4 K or more and 7 K or less of 0.6 $J/(cm^3 \cdot K)$ or more.

The rare earth oxysulfide 10 contained in the cold storage material 100 of the first embodiment includes at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu), oxygen (O), and sulfur (S). The chemical composition of the rare earth oxysulfide 10 is represented by, for example, a general formula $R_{2\pm0.1}O_2S_{1+0.1}$ (wherein R represents at least one rare earth element selected from the group consisting of Y, La, Ce, Pr, Nd, Sm, Eu, Gd, Tb, Dy, Ho, Er, Tm, Yb, and Lu.).

In the rare earth oxysulfide 10 having the chemical composition represented by the above general formula, the maximum value of the volume specific heat and the temperature indicating the maximum value of the volume specific heat are different depending on the selected rare earth element. Therefore, specific heat characteristics can be adjusted by appropriately adjusting the type and ratio of the rare earth element. The rare earth element contained in the rare earth oxysulfide 10 is, for example, at least one element selected from the group consisting of Gd, Tb, Dy, Ho, and Er. The rare earth oxysulfide 10 contained in the cold storage material 100 of the first embodiment may contain, for example, two or more kinds of rare earth elements.

The rare earth oxysulfide 10 is, for example, crystalline. A crystal structure of the rare earth oxysulfide 10 contained in the cold storage material 100 of the first embodiment is, for example, $Ce_2O_2S$ type, and a space group thereof is P-3m.

The cold storage material 100 of the first embodiment contains, for example, a rare earth oxysulfide 10 as a main component. Among the substances contained in the cold storage material 100 of the first embodiment, for example, a volume ratio of the rare earth oxysulfide 10 is the largest. Among the substances contained in the cold storage material 100 of the first embodiment, for example, a molar ratio of the rare earth oxysulfide 10 is the largest.

The garnet-type rare earth oxide 11 contained in the cold storage material 100 of the first embodiment contains at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu), aluminum (Al), and oxygen (O).

The garnet-type rare earth oxide 11 is, for example, crystalline. A crystal structure of the garnet-type rare earth oxide 11 contained in the cold storage material 100 of the first embodiment is a garnet type, and a space group thereof is Ia-3d.

The at least one rare earth element contained in the garnet-type rare earth oxide 11 and the at least one rare earth element contained in the rare earth oxysulfide 10 contain, for example, the same rare earth element. The at least one rare earth element contained in the garnet-type rare earth oxide 11 and the at least one rare earth element contained in the rare earth oxysulfide 10 are, for example, the same rare earth element.

The aluminum oxide 12 included in the cold storage material 100 of the first embodiment is, for example, crystalline.

The cold storage material 100 of the first embodiment contains, for example, 0.001 atom% or more and 10 atom% or less in total of Group 2 elements. The cold storage material 100 may contain, for example, two or more kinds of Group 2 elements.

The Group 2 element is at least one element selected from the group consisting of beryllium (Be), magnesium (Mg), calcium (Ca), strontium (Sr), barium (Ba), and radium (Ra). The Group 2 element is, for example, at least one element selected from the group consisting of magnesium (Mg), calcium (Ca), strontium (Sr), and barium (Ba) .

The cold storage material may contain, for example, two or more kinds of Group 2 elements. The cold storage material may not contain the Group 2 element. The Group 2 element contained in the cold storage material 100 of the first embodiment is contained in, for example, the garnet-type rare earth oxide 11.

Note that the detection of the element contained in the cold storage material 100 and the measurement of the atomic concentration of the element according to the first embodiment can be performed, for example, by dissolving the cold storage material 100 in a liquid and using inductively coupled plasma atomic emission spectrometry (ICP-AES). It is also possible to use energy dispersive X-ray spectroscopy (EDX) or wavelength dispersive X-ray spectroscopy (WDX).

The compound contained in the cold storage material 100 of the first embodiment can be identified by, for example, powder X-ray diffraction measurement (XRD), observation of an electron backscatter diffraction image using a scanning electron microscope (SEM), transmission electron microscope observation, or the like.

The crystal structure of the compound contained in the cold storage material 100 of the first embodiment can be identified by powder X-ray diffraction measurement (XRD), observation of an electron backscatter diffraction image using a scanning electron microscope (SEM), transmission electron microscope observation, or the like.

In the cold storage material 100 of the first embodiment, the ratio of the X-ray diffraction peak intensity of the garnet-type rare earth oxide 11 to the X-ray diffraction peak intensity of the rare earth oxysulfide 10 is 0.1% or more and 40% or less. The X-ray diffraction peak intensity of the rare earth oxysulfide 10 and the garnet-type rare earth oxide 11 is measured by powder X-ray diffraction measurement.

For the powder X-ray diffraction measurement, for example, D8 ADVANCE manufactured by Bruker Corporation is used. For example, Cu is used as a radiation source for measurement. For phase identification in powder X-ray diffraction measurement, for example, DIFFRAC.SUITE which is analysis software manufactured by Bruker Corporation is used.

In the powder X-ray diffraction measurement, the maximum peak of $Ce_2O_2S$ type rare earth oxysulfide (space group P-3m) exists, for example, at 28 degrees or more and 32 degrees or less. The maximum peak of the garnet-type rare earth oxide (space group Ia-3d) is, for example, 32 degrees or more and 34 degrees or less. The maximum peak of the aluminum oxide is, for example, 34 degrees or more and 36 degrees or less.

The ratio of the X-ray diffraction peak intensity of the garnet-type rare earth oxide 11 to the X-ray diffraction peak intensity of the rare earth oxysulfide 10 can be determined, for example, by the ratio between the intensity of the maximum peak present at 28 degrees or more and 32 degrees or less and the intensity of the maximum peak present at 32 degrees or more and 34 degrees or less. The angle at which the maximum peak intensity exists varies depending on the composition of the compound. Therefore, the phase of the rare earth oxysulfide 10 and the phase of the garnet-type rare earth oxide 11 are identified with the analysis software, and the ratio of the intensity of the maximum peak of each phase is determined.

Whether the garnet-type rare earth oxide 11 contains a rare earth element and Al can be confirmed by comprehensively determining a measurement result of powder X-ray diffraction and an observation result by a scanning electron microscope-energy dispersive X-ray element analyzer (SEM-EDX). Specifically, in the reflected electron image of the SEM, the crystal phase detected by the XRD measurement result is allocated to the crystal phase with a different contrast obtained in the SEM image, considering that the region with a high contrast contains a large amount of light elements. As a result, the element contained in the garnet-type rare earth oxide 11 can be confirmed by performing the SEM-EDX measurement on the region of the contrast allocated to the garnet-type rare earth oxide 11.

The grain size (particle diameter) of the compound contained in the cold storage material 100 of the first embodiment is, for example, 1 um or more and 10 um or less. For example, the grain sizes of the rare earth oxysulfide 10, the garnet-type rare earth oxide 11, and the aluminum oxide 12 contained in the cold storage material 100 are 1 um or more and 10 um or less.

The grain size of the compound contained in the cold storage material 100 of the first embodiment is obtained by observing a cross section of the cold storage material 100 with a reflected electron image of a scanning electron microscope (SEM). The grain size is calculated, for example, from the following equation.

$$d = 1.56C/(MN)$$

(d: grain size, C: length of line arbitrarily drawn in high-resolution image such as SEM, N: number of crystal grains arbitrarily drawn on line, M: magnification M of image)

The method for producing the cold storage material 100 of the first embodiment is not particularly limited. For example, it can be produced by mixing raw material powders using a ball mill or the like to adjust a raw material mixture, and molding and sintering the obtained raw material mixture. As the raw material powder, a rare earth oxide or a rare earth oxysulfide can be used. The type and ratio of the rare earth oxide or the rare earth oxysulfide are adjusted in accordance with a target composition of the cold storage material.

By adding alumina having a specific surface area of 1 $m^2/g$ or more and 5 $m^2/g$ or less to the raw material powder, a cold storage material containing the garnet-type rare earth oxide 11 containing a rare earth element and Al can be produced. The amount of alumina used in the raw material powder is desirably 0.1 atom% or more and 30 atom% or less in atom% with respect to the entire raw material powder.

For example, a cold storage material containing the garnet-type rare earth oxide 11 containing the Group 2 element can be produced by using a substance containing the Group 2 element for the raw material powder. As the substance containing the Group 2 element, a carbonate containing the Group 2 element, an oxide containing the Group 2 element, a nitride containing the Group 2 element, or a carbide containing the Group 2 element can be used.

The concentration of the Group 2 element contained in the cold storage material is adjusted by adjusting the amount of the carbonate containing the Group 2 element, the oxide containing the Group 2 element, the nitride containing the Group 2 element, or the carbide containing the Group 2 element.

When the rare earth oxide is used as the raw material powder, a molded body is sulfurized. In this case, heat treatment is performed in a sulfurization atmosphere. The sulfurization atmosphere contains, for example, a gas containing a sulfur atom having a negative oxidation number, such as hydrogen sulfide ($H_2S$) carbon sulfide ($CS_2$) or methanethiol U ($CH_3SH$). A heat treatment temperature is, for example, 400°C or more and 700°C or less. A heat treatment time is, for example, 1 hour or more and 8 hours or less.

The heat treatment for sintering the obtained oxysulfide is performed, for example, in a pressurized atmosphere of an inert gas. The heat treatment temperature is, for example, 1300°C or more and 2000°C or less. The heat treatment temperature is, for example, 1350°C or more and 1700°C or less. The heat treatment time is, for example, 1 hour or more and 48 hours or less.

The cold storage material 100 of the first embodiment may be, for example, a sintered body of cold storage material particles containing the rare earth oxysulfide 10, the garnet-type rare earth oxide 11, and the aluminum oxide 12.

Next, functions and effects of the cold storage material of the first embodiment will be described.

In a cryogenic refrigerator used for cooling a superconducting device or the like, the cold storage material is accommodated in the cold storage device. For example, cold is generated by heat exchange between the cold storage material and helium gas passing through the cold storage device. In order to improve the refrigeration capacity of the refrigerator, for example, it is required to have high volume specific heat for the cold storage material stored in the cold storage device.

In addition, vibration is constantly applied to the cold storage material mounted on the cryogenic refrigerator during the operation of the refrigerator. Therefore, when the strength of the cold storage material is weak, the cold storage material is cracked or chipped. When cracking or chipping occurs, the performance of the refrigerator deteriorates. Therefore, improvement of the strength of the cold storage material is required to improve the reliability of the refrigerator.

The upper limit of the volume specific heat of the cold storage material is limited by the composition of the substance. Meanwhile, the strength of the cold storage material can be improved by reducing the grain size or adding alumina as described in the prior art.

For reducing the grain size, there is a realistic restriction on the minimum value of the grain size. Therefore, it is difficult to further improve the strength by controlling the grain size. In addition, the strength improvement by the addition of alumina has a disadvantage that the volume specific heat decreases when the addition amount of alumina is increased.

In the cold storage material 100 of the first embodiment, the maximum value of the volume specific heat in the temperature range of 2 K or more and 10 K or less is 0.5 $J/(cm^3 \cdot K)$ or more. Therefore, the cold storage material 100 of the first embodiment has high volume specific heat.

The cold storage material 100 of the first embodiment realizes high volume specific heat by containing the rare earth oxysulfide 10 having high volume specific heat. The cold storage material 100 is a ceramic magnetic cold storage material having high volume specific heat.

In addition, the cold storage material 100 of the first embodiment contains the garnet-type rare earth oxide 11, thereby increasing the strength. Therefore, it is possible to suppress a decrease in the occupation ratio of the rare earth oxysulfide 10 by increasing the addition amount of alumina. Therefore, a decrease in volume specific heat of the cold storage material 100 can be suppressed, and high volume specific heat is realized.

The cold storage material of the first embodiment has, for example, the volume specific heat of 0.5 J/(cm$^3$·K) or more in the temperature range of 2.5 K or more and 10 K or less. In addition, for example, the volume specific heat in the temperature range of 2 K or more and 8 K or less is 0.55 J/(cm$^3$·K) or more. In addition, for example, the volume specific heat in the temperature range of 4 K or more and 7 K or less is 0.6 J/(cm$^3$·K) or more.

As described above, the cold storage material 100 of the first embodiment has high volume specific heat. Therefore, for example, the cold storage device accommodating the cold storage material 100 of the first embodiment has high cold storage performance. The refrigerator including the cold storage device storing the cold storage material 100 of the first embodiment exhibits high refrigeration capacity.

The cold storage material 100 of the first embodiment contains the rare earth oxysulfide 10, the garnet-type rare earth oxide 11 containing a rare earth element and Al, and the aluminum oxide 12. The ratio of the X-ray diffraction peak intensity of the garnet-type rare earth oxide 11 to the X-ray diffraction peak intensity of the rare earth oxysulfide 10 is 0.1% or more and 40% or less.

When the ratio of the X-ray diffraction peak intensity of the garnet-type rare earth oxide 11 to the X-ray diffraction peak intensity of the rare earth oxysulfide 10 is 0.1% or more, the strength of the cold storage material 100 is improved. When the ratio of the X-ray diffraction peak intensity of the garnet-type rare earth oxide 11 to the X-ray diffraction peak intensity of the rare earth oxysulfide 10 exceeds 40%, the abundance ratio of the rare earth oxysulfide 10 decreases, and thus the volume specific heat significantly decreases. In other words, since the ratio of the X-ray diffraction peak intensity of the garnet-type rare earth oxide 11 to the X-ray diffraction peak intensity of the rare earth oxysulfide 10 is 40% or less, the cold storage material 100 can realize high volume specific heat.

In addition, the cold storage material 100 of the first embodiment has higher strength than the cold storage material not including the garnet-type rare earth oxide 11 even when the grain size of the contained compound is large. This is considered to be because the garnet-type rare earth oxide 11 has high symmetry because of the cubic crystal, and the force can be isotropically released even when the force is applied from the outside.

The strength improving effect by containing the garnet-type rare earth oxide 11 is not affected by the amount of other sub-phases. For example, when alumina or a perovskite-type rare earth oxide is contained as the sub-phase, regardless of the value of the ratio of the X-ray diffraction peak intensity of alumina or the X-ray diffraction peak intensity of the perovskite-type rare earth oxide to the X-ray diffraction peak intensity of the rare earth oxysulfide 10, the intensity improving effect is exhibited when the ratio of the X-ray diffraction peak intensity of the garnet-type rare earth oxide 11 to the X-ray diffraction peak intensity of the rare earth oxysulfide 10 is 0.1% or more and 40% or less. This is considered to be because the strength improvement effect is derived only from the presence of the garnet-type rare earth oxide 11, and is not affected by other sub-phases.

From the viewpoint of improving the strength of the cold storage material 100, the ratio of the X-ray diffraction peak intensity of the garnet-type rare earth oxide 11 to the X-ray diffraction peak intensity of the rare earth oxysulfide 10 is preferably 1% or more, and more preferably 3% or more. From the viewpoint of achieving high volume specific heat of the cold storage material 100, the ratio of the X-ray diffraction peak intensity of the garnet-type rare earth oxide 11 to the X-ray diffraction peak intensity of the rare earth oxysulfide 10 is preferably 20% or less, more preferably 10% or less, and still more preferably 5% or less.

The Group 2 element has an effect of promoting the production of the garnet-type rare earth oxide 11. This is considered to be because the rare earth site of the garnet-type rare earth oxide 11 is occupied by the Group 2 element, whereby the garnet-type structure can be stabilized. Therefore, when the cold storage material 100 contains the Group 2 element, the strength of the cold storage material 100 is further improved.

The atomic concentration of the Group 2 element in the cold storage material 100 is preferably 0.001 atom% or more, more preferably 0.01% or more, and still more preferably 0.05% or more. When the atomic concentration of the Group 2 element exceeds the above lower limit, the production of the garnet-type rare earth oxide 11 is promoted, and the strength of the cold storage material 100 is improved.

The atomic concentration of the Group 2 element contained in the cold storage material 100 is preferably 10 atom% or less, and more preferably 5 atom% or less. The Group 2 element does not contribute to improvement in volume specific heat of the cold storage material 100. Therefore, when the atomic concentration of the Group 2 element falls below the upper limit value, high volume specific heat of the cold storage material 100 can be realized.

The Group 2 element contained in the cold storage material 100 is preferably, for example, at least one element selected from the group consisting of Mg, Ca, Sr, and Ba. When the Group 2 element is the above element, the strength of the cold storage material 100 can be improved, and high volume specific heat of the cold storage material 100 can be realized.

In addition, since the Group 2 element has a sintering promoting effect, the sulfurization and sintering temperature can be lowered.

(Modification)

A modification of the cold storage material of the first embodiment contains a perovskite-type rare earth oxide.

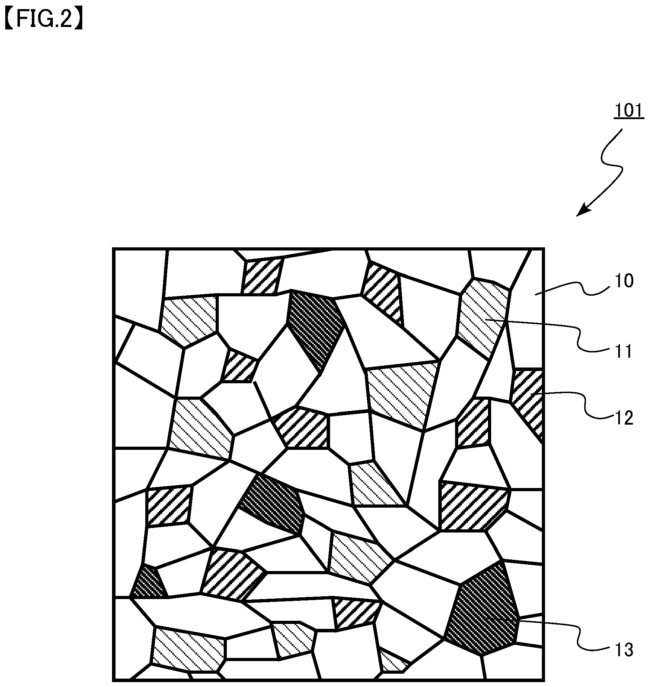

FIG. 2 is a schematic cross-sectional view of a cold storage material according to a modification of the first embodiment.
A cold storage material 101 according to the modification of the first embodiment contains the rare earth oxysulfide 10, the garnet-type rare earth oxide 11, the aluminum oxide 12, and a perovskite-type rare earth oxide 13.
The perovskite-type rare earth oxide 13 contained in the cold storage material 101 contains at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu), aluminum (Al), and oxygen (O).
The at least one rare earth element contained in the perovskite-type rare earth oxide 13, the at least one rare earth element contained in the rare earth oxysulfide 10, and the at least one rare earth element contained in the garnet-type rare earth oxide 11 contain, for example, the same rare earth element. The at least one rare earth element contained in the perovskite-type rare earth oxide 13, the at least one rare earth element contained in the rare earth oxysulfide 10, and the at least one rare earth element contained in the garnet-type rare earth oxide 11 are, for example, the same rare earth element.
The perovskite-type rare earth oxide 13 is, for example, crystalline. The crystal structure of the perovskite-type rare earth oxide 13 included in the cold storage material 101 is a perovskite-type, and the space group thereof is Pnma.
In the powder X-ray diffraction measurement, the maximum peak of the perovskite-type rare earth oxide 13 is, for example, 33.5 degrees or more and 35 degrees or less. The maximum peak intensity of the perovskite-type rare earth oxide 13 is lower than the maximum peak intensity of the rare earth oxysulfide 10. The maximum peak intensity of the perovskite-type rare earth oxide 13 is lower than the maximum peak intensity of the garnet-type rare earth oxide 11, for example.
As described above, according to the first embodiment and the modification, it is possible to realize a cold storage material having excellent characteristics such as high volume specific heat and high strength.

(Second Embodiment)

A cold storage material particle of a second embodiment is formed of the cold storage material of the first embodiment, and has a particle diameter of 50 um or more and 3 mm or less. Hereinafter, description of contents overlapping with the first embodiment may be partially omitted.

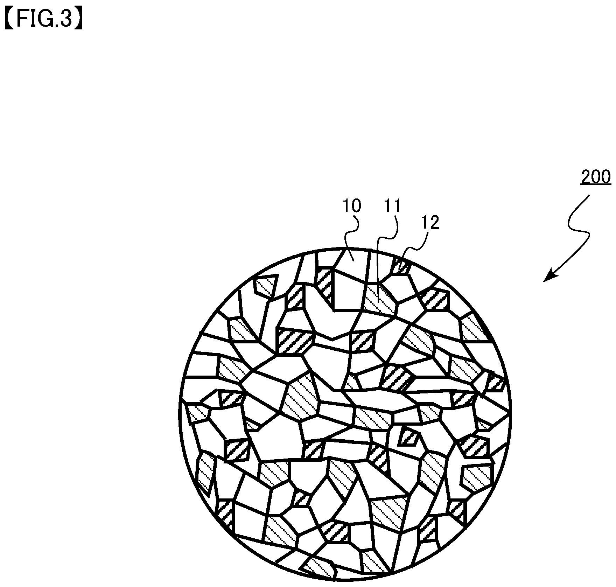

FIG. 3 is a schematic cross-sectional view of a cold storage material particle according to a second embodiment. A cold storage material particle 200 of the second embodiment is formed of the cold storage material 100 of the first embodiment.
The shape of the cold storage material particle 200 of the second embodiment is, for example, spherical. The cold storage material particle 200 has a particle diameter of 50 um or more and 3 mm or less.
The particle diameter of the cold storage material particle 200 is an equivalent circle diameter. The equivalent circle diameter is a diameter of a perfect circle corresponding to an area of a figure observed in an image such as an optical microscope image or a scanning electron microscope image (SEM image). The particle diameter of the cold storage material particle 200 can be obtained, for example, by image analysis of an optical microscope image or an SEM image.
The aspect ratio of the cold storage material particle 200 is, for example, 1 or more and 5 or less. The aspect ratio of the cold storage material particle is the ratio of the major axis to the minor axis of the cold storage material particle 200.
The cold storage material particle 200 of the second embodiment contains the rare earth oxysulfide 10, the garnet-type rare earth oxide 11, and the aluminum oxide 12.
The method for producing the cold storage material particle 200 of the second embodiment is not particularly limited. In the case of producing the cold storage material particle 200, for example, granulated particles to be a raw material of the cold storage material particle 200 are formed from a raw material powder. Thereafter, the granulated particles are sintered to produce the cold storage material particles 200.
In the first method for forming granulated particles, for example, a raw material powder is mixed using a ball mill or the like to prepare a raw material mixture. Then, the obtained raw material mixture is formed (granulated) into particles by a tumbling granulation method, a stirring granulation method, an extrusion method, a spraying method (spray method), a press molding method or the like to form granulated particles.
In the first method, the strength of the granulated particles is improved by adding a binder to adhere the raw material powders to each other. The binder is, for example, polyvinyl alcohol, polyvinyl butyral, carboxymethyl cellulose, an acrylic resin, or polyethylene glycol. The addition amount of the binder is, for example, 0.01 wt% or more and 20 wt% or less.

As the raw material powder, a rare earth oxide or a rare earth oxysulfide can be used. The type and ratio of the rare earth oxide or the rare earth oxysulfide are adjusted in accordance with the target composition of the cold storage material particle.

For example, cold storage material particles containing a garnet-type rare earth oxide can be produced by using alumina having a specific surface area of 1 $m^2$/g or more and 5 $m^2$/g or less and a substance having the Group 2 element for the raw material powder. The amount of alumina used in the raw material powder is, for example, 0.1 atom% or more and 30 atom% or less in atom% with respect to the entire raw material powder. In addition, as the substance having the Group 2 element, a carbonate containing the Group 2 element, an oxide containing the Group 2 element, a nitride containing the Group 2 element, or a carbide containing the Group 2 element can be used.

In the second method for forming granulated particles, a slurry prepared by adding a raw material powder to an alginic acid aqueous solution and mixing the raw material powder with the alginic acid aqueous solution is added dropwise to a gelling solution, and the slurry is gelled to granulate the slurry into particles to form granulated particles. The second method is a method of granulating particles by causing gelation to proceed by a crosslinking reaction by polyvalent metal ions contained in a gelling solution. For dropping the slurry into the gelling solution, for example, a dropper, a burette, a pipette, a syringe, a dispenser, an inkjet, or the like can be used. Hereinafter, the particle granulation method by the second method is referred to as an alginic acid gel method.

In the alginic acid gel method, the particle diameter and aspect ratio of the particles can be changed by adjusting viscosity of slurry, a diameter of a discharge port at the time of dropping, or the distance between a tip of the discharge port and a liquid level of a gelling solution. The diameter of the discharge port is, for example, 50 um or more and 3000 um or less. The viscosity of the slurry is, for example, 0.1 mPa·s or more and 1,000,000 mPa·s or less. A distance between the tip of the discharge port and the liquid level of the gelling solution is, for example, 0.1 mm or more and 1000 mm or less.

When the dispenser is used for dispensing, any of an air pulse dispenser, a plunger dispenser, and a piezo dispenser may be used as the device.

The inkjet is largely divided into a continuous type and an on-demand type as an ejection method, but any type of ejection method may be used. Further, the on-demand type is divided into three types of a piezo type, a thermal type, and a valve type, but any type may be used.

The slurry dropped on the gelling solution by a dropper, a burette, a pipette, a syringe, a dispenser, an inkjet, or the like is held in the gelling solution to be gelled. By gelling the slurry, granulated particles containing the raw material powder of the cold storage material are formed. The retention time of the slurry in the gelling solution is, for example, 10 minutes or more and 48 hours or less.

The alginic acid aqueous solution used in the alginic acid gel method is, for example, a sodium alginate aqueous solution, an ammonium alginate aqueous solution, or a potassium alginate aqueous solution.

As the gelling solution, for example, a calcium lactate aqueous solution, a calcium chloride aqueous solution, a manganese (II) chloride aqueous solution, a magnesium sulfate aqueous solution, a beryllium sulfate aqueous solution, a strontium nitrate aqueous solution, a barium chloride aqueous solution, or a barium hydroxide aqueous solution can be used as the aqueous solution containing the Group 2 element.

In addition, an aluminum chloride aqueous solution, an aluminum nitrate aqueous solution, an aluminum lactate aqueous solution, an iron (II) chloride aqueous solution, an iron (III) chloride aqueous solution, a copper (II) chloride aqueous solution, a nickel (II) chloride aqueous solution, and a cobalt (II) chloride aqueous solution can be used as a gelling solution.

By using a calcium lactate aqueous solution, a calcium chloride aqueous solution, a magnesium sulfate aqueous solution, a beryllium sulfate aqueous solution, a strontium nitrate aqueous solution, a barium chloride aqueous solution, and barium hydroxide aqueous solution as the gelling solution, the Group 2 element such as calcium, magnesium, beryllium, strontium, or barium can be contained in the cold storage material particles.

At least two kinds of aqueous solutions containing different metal elements selected from the group consisting of a calcium lactate aqueous solution, a calcium chloride aqueous solution, a magnesium sulfate aqueous solution, a beryllium sulfate aqueous solution, a strontium nitrate aqueous solution, a barium chloride aqueous solution, and a barium hydroxide aqueous solution may be mixed and used as the gelling solution, whereby two or more kinds of Group 2 elements can be contained in the cold storage material particles.

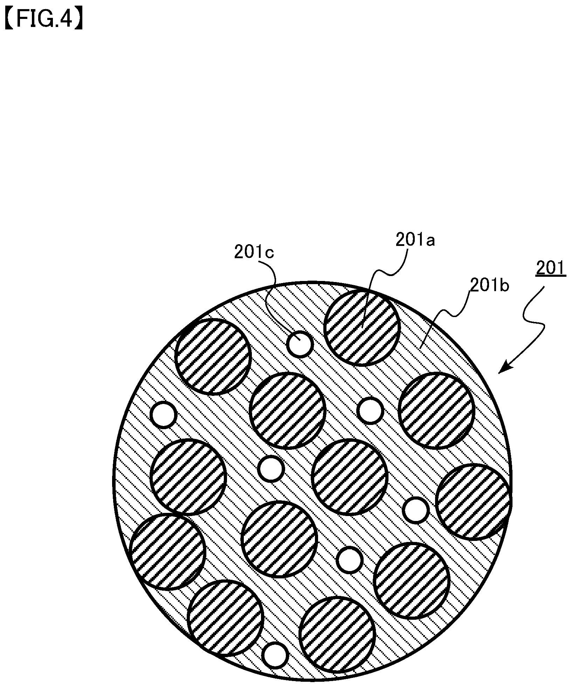

FIG. 4 is a schematic cross-sectional view of a granulated particle of a second embodiment. A granulated particle 201 of the second embodiment is a granulated particle for producing the cold storage material particle 200 of the second embodiment. The granulated particle 201 of the second embodiment is a raw material of the cold storage material particle 200 of the second embodiment.

As shown in FIG. 4, the granulated particles 201 of the second embodiment include, for example, a raw material powder 201a, a binder 201b, and a void 201c. The granulated particles 201 may contain, for example, a dispersion medium instead of the binder 201b. The granulated particles 201 may contain, for example, a gelling agent instead of the binder 101b. The raw material powder 201a may contain, for example, a sintering aid for promoting sintering at the time of producing the cold storage material particle 200.

The granulated particles 201 are formed by, for example, granulating the raw material powder 201a by the first method or the second method. The granulated particles 201 are formed, for example, by binding a plurality of raw material powders 201a by a binder 201b.

The granulated particle 201 is, for example, a gel. The granulated particle 201 is formed, for example, by gelling a plurality of raw material powders 201a using a gelling agent (gelling solution). For example, the raw material powder 201a loses independent mobility and is in a state of being aggregated and solidified.

The particle diameter of the granulated particles 201 is, for example, 70 um or more and 5 mm or less. The aspect ratio of the granulated particles 201 is, for example, 1 or more and 5 or less.

By degreasing the granulated particles 201, a certain amount of organic components can be removed. In a case where the raw material is an oxide, when degreasing is insufficient, sulfurization does not sufficiently proceed, and a required amount of oxysulfide cannot be generated. Furthermore, when the degreasing is insufficient and the organic component remains too much, the density of the sintered particles decreases. Therefore, the strength of the cold storage material particle 200 becomes weak, and the cold storage material particle cannot withstand use in a refrigerator.

When the degreasing proceeds too much, the organic component securing the strength disappears, so that the strength of the degreased granulated particles 201 decreases, and the particles are cracked or chipped. A degreasing temperature is, for example, 400°C or more and 800°C or less, and a time thereof is 30 minutes or more and 12 hours or less.

When a rare earth oxide is used as the raw material powder, the granulated particles 201 are sulfurized. In this case, heat treatment is performed in a sulfurization atmosphere. The sulfurization atmosphere contains, for example, a gas containing a sulfur atom having a negative oxidation number, such as hydrogen sulfide ($H_2S$), carbon sulfide ($CS_2$), or methanethiol ($CH_3SH$). A heat treatment temperature is, for example, 400°C or more and 700°C or less. A heat treatment time is, for example, 1 hour or more and 8 hours or less.

The heat treatment for sintering the granulated particles 201 is performed, for example, in a pressurized atmosphere of an inert gas. The heat treatment temperature is, for example, 1300°C or more and 1700°C or less. The heat treatment time is, for example, 1 hour or more and 48 hours or less.

Next, functions and effects of the cold storage material particle of the second embodiment will be described.

The cold storage material particle 200 of the second embodiment is formed of the cold storage material of the first embodiment. Therefore, in the cold storage material particle 200 of the second embodiment, the maximum value of the volume specific heat in the temperature range of 2 K or more and 10 K or less is 0.5 $J/(cm^3 \cdot K)$ or more. Therefore, the cold storage material particle 200 of the second embodiment has high volume specific heat.

In addition, the cold storage material particle 200 of the second embodiment has, for example, volume specific heat of 0.5 $J/(cm^3 \cdot K)$ or more in a temperature range of 2.5 K or more and 10 K or less. In addition, for example, the volume specific heat in the temperature range of 2 K or more and 8 K or less is 0.55 $J/(cm^3 \cdot K)$ or more. In addition, for example, the volume specific heat in the temperature range of 4 K or more and 7 K or less is 0.6 $J/(cm^3 \cdot K)$ or more.

Since the cold storage material particle 200 of the second embodiment has high volume specific heat, the cold storage device accommodating the cold storage material particle 200 of the second embodiment has high cold storage performance. In addition, the refrigerator including the cold storage device containing the cold storage material particle 200 of the second embodiment exhibits high refrigeration capacity.

The cold storage material particle 200 of the second embodiment contains the rare earth oxysulfide 10, the garnet-type rare earth oxide 11 containing a rare earth element and Al, and the aluminum oxide 12. The ratio of the X-ray diffraction peak intensity of the garnet-type rare earth oxide 11 to the X-ray diffraction peak intensity of the rare earth oxysulfide 10 is 0.1% or more and 40% or less.

When the ratio of the X-ray diffraction peak intensity of the garnet-type rare earth oxide 11 to the X-ray diffraction peak intensity of the rare earth oxysulfide 10 is 0.1% or more, the intensity of the cold storage material particle 200 is improved. When the ratio of the X-ray diffraction peak intensity of the garnet-type rare earth oxide 11 to the X-ray diffraction peak intensity of the rare earth oxysulfide 10 exceeds 40%, the abundance ratio of the rare earth oxysulfide 10 decreases, and thus the volume specific heat significantly decreases. In other words, since the ratio of the X-ray diffraction peak intensity of the garnet-type rare earth oxide 11 to the X-ray diffraction peak intensity of the rare earth oxysulfide 10 is 40% or less, the cold storage material particle 200 can realize high volume specific heat.

In addition, the cold storage material particle 200 of the second embodiment has higher strength than the cold storage material particle not containing the garnet-type rare earth oxide 11 even when the grain size of the contained compound is large. This is considered to be because the garnet-type rare earth oxide 11 has high symmetry because of the cubic crystal, and the force can be isotropically released even when the force is applied from the outside.

The strength improving effect by containing the garnet-type rare earth oxide 11 is not affected by the amount of other sub-phases. For example, when alumina or a perovskite-type rare earth oxide is contained as the sub-phase, regardless of the value of the ratio of the X-ray diffraction peak intensity of alumina or the X-ray diffraction peak intensity of the perovskite-type rare earth oxide to the X-ray diffraction peak intensity of the rare earth oxysulfide 10, the intensity improving effect is exhibited when the ratio of the X-ray diffraction peak intensity of the garnet-type rare earth oxide 11 to the X-ray diffraction peak intensity of the rare earth oxysulfide 10 is 0.1% or more and 40% or less. This is considered to be because the strength improvement effect is derived only from the presence of the garnet-type rare earth oxide 11, and is not affected by other sub-phases.

From the viewpoint of improving the strength of the cold storage material particle 200, the ratio of the X-ray diffraction peak intensity of the garnet-type rare earth oxide 11 to the X-ray diffraction peak intensity of the rare earth oxysulfide 10 is preferably 1% or more, and more preferably 3% or more. From the viewpoint of achieving high volume specific heat of the cold storage material particle 200, the ratio of the X-ray diffraction peak intensity of the garnet-type rare earth oxide 11 to the X-ray diffraction peak intensity of the rare earth oxysulfide 10 is preferably 20% or less, more preferably 10% or less, and still more preferably 5% or less.

The Group 2 element has an effect of promoting the production of the garnet-type rare earth oxide 11. This is considered to be because the rare earth site of the garnet-type rare earth oxide 11 is occupied by the Group 2 element, whereby the garnet-type structure can be stabilized. Therefore, when the cold storage material particle 200 contains the Group 2 element, the strength of the cold storage material particle 200 is improved.

As the strength of the cold storage material particle 200 is improved, the cold storage material particle 200 is less likely to be broken. Therefore, the reliability of the refrigerator including the cold storage device filled with the cold storage material particle 200 is improved.

The atomic concentration of the Group 2 element in the cold storage material particle 200 is preferably 0.001 atom% or more, more preferably 0.01% or more, and still more preferably 0.05% or more. When the atomic concentration of the Group 2 element exceeds the above lower limit, the production of the garnet-type rare earth oxide 11 is promoted, and the strength of the cold storage material particle 200 is improved.

The atomic concentration of the Group 2 element contained in the cold storage material particle 200 is preferably 10 atom% or less, and more preferably 5 atom% or less. The Group 2 element does not contribute to improvement in volume specific heat of the cold storage material particle 200. Therefore, when the atomic concentration of the Group 2 element is less than the upper limit value, high volume specific heat of the cold storage material particle 200 can be realized.

The cold storage material particles 200 containing the Group 2 element can be produced by using a carbonate containing the Group 2 element, an oxide containing the Group 2 element, a nitride containing the Group 2 element, or a carbide containing the Group 2 element in the raw material powder. The concentration of the Group 2 element contained in the cold storage material particle 200 is adjusted by adjusting the amount of the carbonate containing the Group 2 element, the oxide containing the Group 2 element, the nitride containing the Group 2 element, or the carbide containing the Group 2 element.

In addition, since the Group 2 element has a sintering promoting effect, the sulfurization and sintering temperature can be lowered.

The particle diameter of the cold storage material particle 200 of the second embodiment is preferably 50 um or more and 3 mm or less, more preferably 1 mm or less, and still more preferably 500 um or less. When the particle diameter of the cold storage material particle 200 exceeds the above lower limit value, the packing density of the cold storage material particle 200 in the cold storage device is lowered, the pressure loss of the working medium such as helium is reduced, and the refrigeration performance of the refrigerator is improved. Meanwhile, when the particle diameter of the cold storage material particle 200 is less than the upper limit value, the distance from the surface of the cold storage material particle 200 to the particle center portion is shortened, heat transfer between the working medium and the cold storage material particle is easily transferred to the cold storage material center portion, and the refrigeration performance of the refrigerator is improved.

The aspect ratio of the cold storage material particle 200 is preferably 1 or more and 5 or less, and more preferably 1 or more and 2 or less. When the aspect ratio of the cold storage material particle 200 is less than the above upper limit value, voids when the cold storage material particle 200 fills the cold storage device become uniform, and the refrigeration performance of the refrigerator is improved.

As described above, according to the second embodiment, it is possible to realize a cold storage material particle having excellent characteristics such as high volume specific heat and high strength.

(Third Embodiment)

The cold storage device of the third embodiment is a cold storage device filled with the cold storage material of the first embodiment or a plurality of cold storage material particles of the second embodiment.

In the cold storage device of the third embodiment, it is preferable that the ratio of the cold storage material particles having a circularity R of 0.5 or less represented by $4\pi A/L^2$ is 5% or less, where L is the perimeter of the projection image and A is the actual area of the projection image, of the plurality of filling cold storage material particles of the second embodiment.

The circularity R can be obtained by performing image processing on the shapes of a plurality of cold storage material particles with an optical microscope. The cold storage material particle having a circularity R of 0.5 or less represents a shape such as presence of irregularities on the surface. When a plurality of cold storage material particles containing more than 5% of such cold storage material particles fill the cold storage device, the porosity formed by the cold storage material particles in the cold storage device becomes non-uniform, and the filling property becomes unstable. Therefore, when the working medium flows in, the cold storage performance is deteriorated, or the cold storage material particles move or break due to stress applied to the cold storage material particles at the time of filling of the cold storage material particles or at the time of operating the refrigerator, and fine particles are generated to clog voids. Therefore, the refrigeration performance and the long-term reliability of the refrigerator are lowered. The cold storage material particle having a circularity R of 0.5 or less is more preferably 2% or less, and still more preferably 0%.

As described above, according to the third embodiment, a cold storage device including a cold storage material or a cold storage material particle having excellent characteristics of high volume specific heat and high strength can be realized.

(Fourth Embodiment)

A refrigerator of the fourth embodiment is a refrigerator including a cold storage device filled with the cold storage material of the first embodiment or a plurality of cold storage material particles of the second embodiment. The refrigerator of the fourth embodiment is a refrigerator including the cold storage device of the third embodiment. Hereinafter, description of contents overlapping with the first embodiment, the second embodiment, and the third embodiment will be partially omitted.

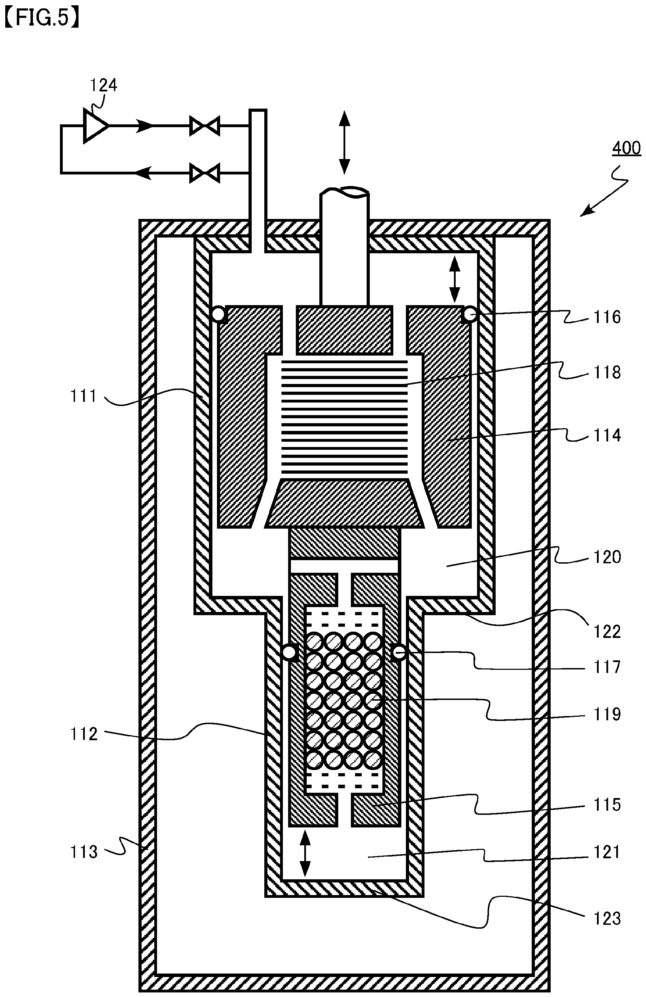

FIG. 5 is a schematic cross-sectional view illustrating a configuration of a main part of the refrigerator according to the fourth embodiment. The refrigerator of the fourth embodiment includes the cold storage device of the third embodiment filled with the cold storage material of the first embodiment or a plurality of cold storage material particles of the second embodiment. The refrigerator of the fourth embodiment is a two-stage cold storage type cryogenic refrigerator 400 used for cooling a superconducting device or the like. The refrigerator of the fourth embodiment is a two-stage GM refrigerator.

The cold storage type cryogenic refrigerator 400 includes a first cylinder 111, a second cylinder 112, a vacuum container 113, a first cold storage device 114, a second cold storage device 115, a first seal ring 116, a second seal ring 117, a first cold storage material 118, a second cold storage material 119, a first expansion chamber 120, a second expansion chamber 121, a first cooling stage 122, a second cooling stage 123, and a compressor 124.

The cold storage type cryogenic refrigerator 400 includes the vacuum container 113 in which a large-diameter first cylinder 111 and a small-diameter second cylinder 112 coaxially connected to the first cylinder 111 are installed. The first cold storage device 114 is disposed in the first cylinder 111 so as to be reciprocable. In the second cylinder 112, the second cold storage device 115, which is an example of the cold storage device of the third embodiment, is disposed so as to be reciprocable.

A first seal ring 116 is disposed between the first cylinder 111 and the first cold storage device 114. The second seal ring 117 is disposed between the second cylinder 112 and the second cold storage device 115.

The first cold storage device 114 accommodates the first cold storage material 118 such as a Cu mesh. The second cold storage device 115 accommodates the second cold storage material 119.

The first cold storage device 114 and the second cold storage device 115 each have a working medium passage provided in a gap between the first cold storage material 118 and the second cold storage material 119. The working medium is helium gas.

The first expansion chamber 120 is provided between the first cold storage device 114 and the second cold storage device 115. The second expansion chamber 121 is provided between the second cold storage device 115 and a distal end wall of the second cylinder 112. The first cooling stage 122 is provided at the bottom of the first expansion chamber 120. The second cooling stage 123 having a temperature lower than that of the first cooling stage 122 is formed at the bottom of the second expansion chamber 121.

A high-pressure working medium is supplied from the compressor 124 to the above-described two-stage cold storage type cryogenic refrigerator 400. The supplied working medium passes between the first cold storage materials 118 housed in the first cold storage device 114 and reaches the first expansion chamber 120. Then, the refrigerant passes between the second cold storage materials 119 housed in the second cold storage device 115 and reaches the second expansion chamber 121.

At this time, the working medium is cooled by supplying thermal energy to the first cold storage material 118 and the second cold storage material 119. The working medium passing between the first cold storage material 118 and the second cold storage material 119 expands in the first expansion chamber 120 and the second expansion chamber 121 to generate cold. Then, the first cooling stage 122 and the second cooling stage 123 are cooled.

The expanded working medium flows in the opposite direction between the first cold storage material 118 and the second cold storage material 119. The working medium is discharged after receiving thermal energy from the first cold storage material 118 and the second cold storage material 119. The cold storage type cryogenic refrigerator 400 is configured such that the thermal efficiency of the working medium cycle is improved as the recuperating effect is improved in such a process, and a lower temperature is realized.

The cold storage device included in the refrigerator of the fourth embodiment accommodates, for example, the cold storage material 100 of the first embodiment in the second cold storage device 115 as at least a part of the second cold storage material 119. For example, the second cold storage device 115 may be filled with a plurality of the cold storage material particles 200 of the second embodiment as at least a part of the second cold storage material 119. When the perimeter of each projection image of the cold storage material particles is L and the actual area of the projection image is A and circularity R is represented by $4\pi A/L^2$, it is preferable that a ratio of cold storage material particles having the circularity R less than or equal to 0.5 in the plurality of cold storage material particles 200 is 5% or less.

In the fourth embodiment, the cold storage device of the third embodiment may include, for example, a plurality of cold storage material filling layers of different types of cold storage materials. The different types of cold storage materials may be divided by a mesh. The mesh is, for example, a metal mesh. At least one of the plurality of cold storage material filling layers includes the cold storage material 100 of the first embodiment or the cold storage material particle 200 of the second embodiment. In the refrigerator of the fourth embodiment, the cold storage material 100 of the first embodiment or the plurality of cold storage material particles 200 of the second embodiment fill, for example, the low-temperature side of the cold storage device.

In order to improve the refrigeration capacity and the long-term reliability of the refrigerator, it is desirable to improve the specific heat per unit volume of the cold storage material and to improve the strength of the cold storage material. The refrigerator of the fourth embodiment includes a cold storage material or cold storage material particles having high volume specific heat and high strength. Therefore, the refrigeration capacity and the long-term reliability of the refrigerator are improved.

For example, by using the refrigerator of the fourth embodiment for a magnetically levitated train, a helium re-condensing device, and the like, it is possible to improve the long-term reliability of the magnetically levitated train and the helium re-condensing device.

As described above, according to the fourth embodiment, it is possible to realize a refrigerator having excellent characteristics by using a cold storage material having excellent characteristics or cold storage material particles.

(Fifth Embodiment)

A cryopump according to a fifth embodiment includes the refrigerator according to the fourth embodiment. Hereinafter, description of contents overlapping with the fourth embodiment will be partially omitted.

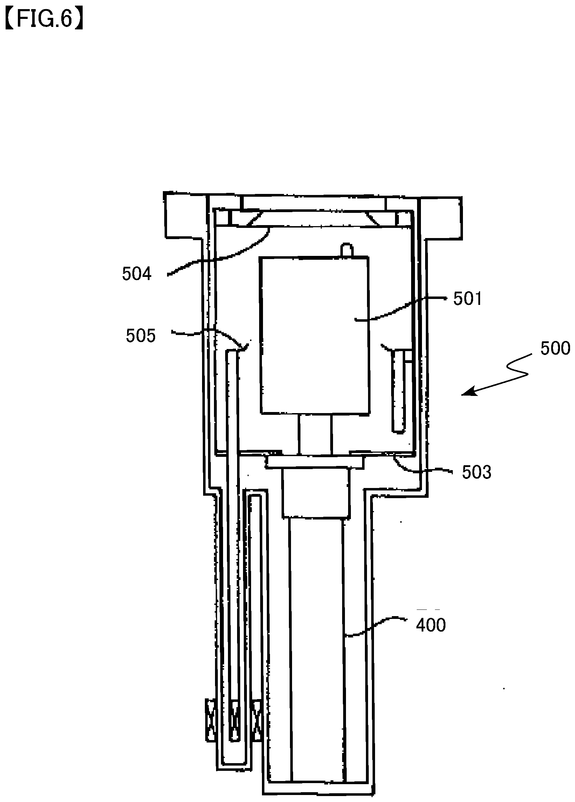

FIG. 6 is a cross-sectional view illustrating a schematic configuration of a cryopump according to a fifth embodiment. The cryopump according to the fifth embodiment is a cryopump 500 including the cold storage type cryogenic refrigerator 400 according to the fourth embodiment.

The cryopump 500 includes a cryopanel 501 that condenses or adsorbs gas molecules, the cold storage type cryogenic refrigerator 400 that cools the cryopanel 501 to a predetermined cryogenic temperature, a shield 503 provided between the cryopanel 501 and the cold storage type cryogenic refrigerator 400, a baffle 504 provided at an intake port, and a ring 505 that changes an exhaust speed of argon, nitrogen, hydrogen, or the like.

According to the fifth embodiment, a cryopump having excellent characteristics can be realized by using a refrigerator having excellent characteristics. By using the cryopump according to the fifth embodiment in a semiconductor manufacturing apparatus, long-term reliability of the semiconductor manufacturing apparatus can be improved.

(Sixth Embodiment)

A superconducting magnet of the sixth embodiment includes the refrigerator of the fourth embodiment. Hereinafter, description of contents overlapping with the fourth embodiment will be partially omitted.

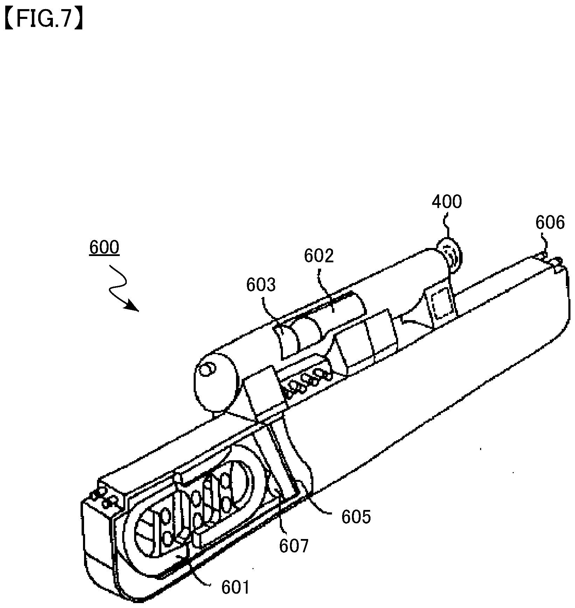

FIG. 7 is a schematic perspective view illustrating a schematic configuration of the superconducting magnet according to a sixth embodiment; The superconducting magnet of the sixth embodiment is, for example, a superconducting magnet 600 for a magnetically levitated train including the cold storage type cryogenic refrigerator 400 of the fourth embodiment.

The superconducting magnet 600 for a magnetically levitated train includes a superconducting coil 601, a liquid helium tank 602 for cooling the superconducting coil 601, a liquid nitrogen tank 603 for preventing volatilization of liquid helium, a laminated heat insulating material 605, a power lead 606, a permanent current switch 607, and the cold storage type cryogenic refrigerator 400.

According to the sixth embodiment, a superconducting magnet having excellent characteristics can be realized by using a refrigerator having excellent characteristics.

(Seventh Embodiment)

A nuclear magnetic resonance imaging apparatus of a seventh embodiment includes the refrigerator of the fourth embodiment. Hereinafter, description of contents overlapping with the fourth embodiment will be partially omitted.

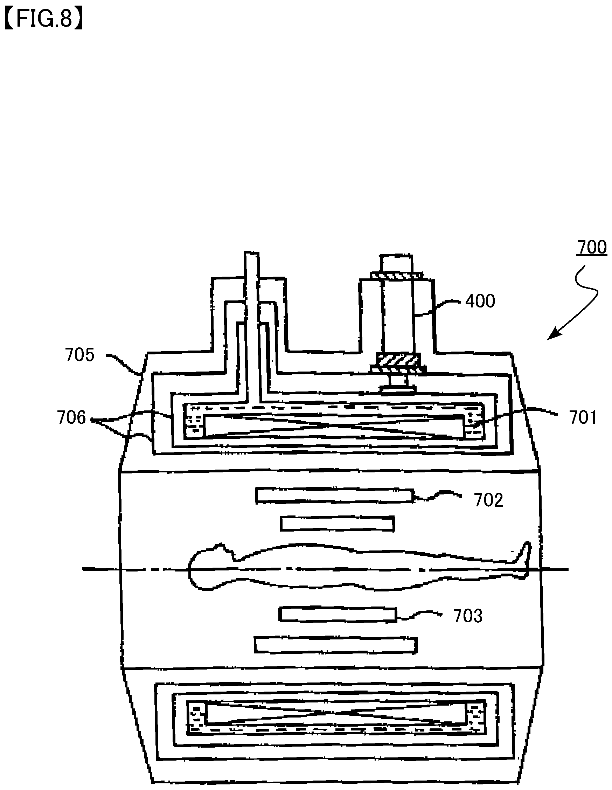

FIG. 8 is a schematic cross-sectional view illustrating a schematic configuration of the nuclear magnetic resonance imaging apparatus of a seventh embodiment. The nuclear magnetic resonance imaging (MRI) apparatus of a seventh embodiment is a nuclear magnetic resonance imaging apparatus 700 including the cold storage type cryogenic refrigerator 400 of the fourth embodiment.

The nuclear magnetic resonance imaging apparatus 700 includes a superconducting static magnetic field coil 701 that applies a spatially uniform and temporally stable static magnetic field to a human body, a correction coil (not illustrated) that corrects nonuniformity of a generated magnetic field, a gradient magnetic field coil 702 that gives a magnetic field gradient to a measurement region, a radio wave transmission/reception probe 703, a cryostat 705, and a radiation adiabatic shield 706. A cold storage type cryogenic refrigerator 400 is used for cooling the superconducting static magnetic field coil 701.

According to the seventh embodiment, a nuclear magnetic resonance imaging apparatus having excellent characteristics can be realized by using a refrigerator having excellent characteristics.

(Eighth Embodiment)

A nuclear magnetic resonance apparatus of an eighth embodiment includes the refrigerator of the fourth embodiment. Hereinafter, description of contents overlapping with the fourth embodiment will be partially omitted.

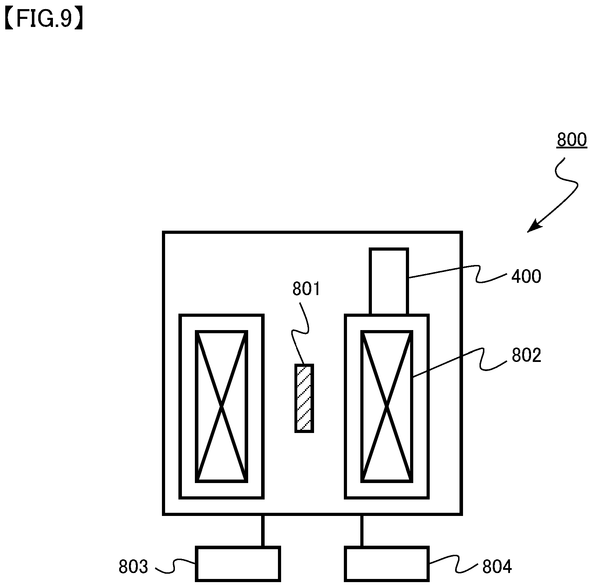

FIG. 9 is a schematic diagram illustrating a schematic configuration of the nuclear magnetic resonance apparatus of an eighth embodiment. The nuclear magnetic resonance (NMR) apparatus of an eighth embodiment is a nuclear magnetic resonance apparatus 800 including the cold storage type cryogenic refrigerator 400 of the fourth embodiment.

The nuclear magnetic resonance apparatus 800 includes a superconducting static magnetic field coil 802 that applies a magnetic field to a sample such as an organic substance placed in a sample tube 801, a high frequency oscillator 803 that applies a radio wave to the sample tube 801 in the magnetic field, and an amplifier 804 that amplifies an induced current generated in a coil (not illustrated) around the sample tube 801. In addition, a cold storage type cryogenic refrigerator 400 that cools the superconducting static magnetic field coil 802 is provided.

According to the eighth embodiment, a nuclear magnetic resonance apparatus having excellent characteristics can be realized by using a refrigerator having excellent characteristics.

(Ninth Embodiment)

A magnetic field application type single crystal pulling apparatus of a ninth embodiment includes the refrigerator of the fourth embodiment. Hereinafter, description of contents overlapping with the fourth embodiment will be partially omitted.

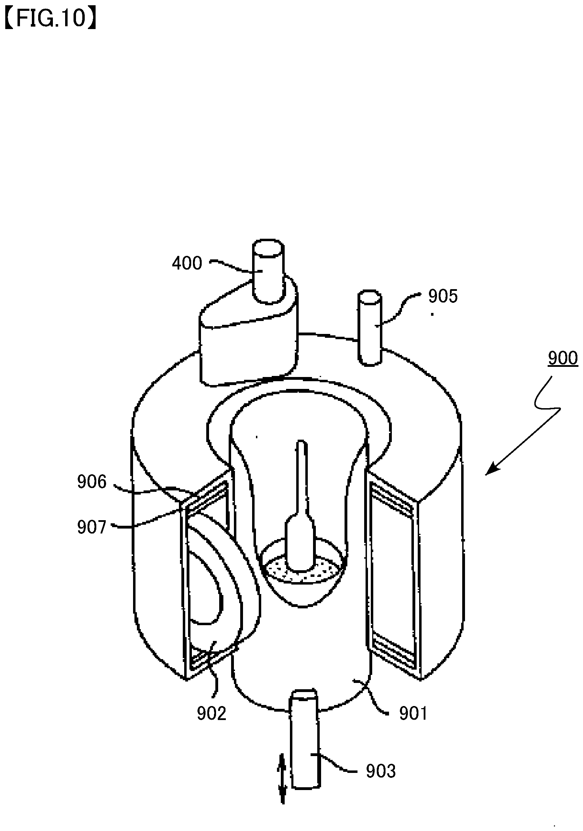

FIG. 10 is a schematic perspective view illustrating a schematic configuration of the magnetic field application type single crystal pulling apparatus according to a ninth embodiment; The magnetic field application type single crystal pulling apparatus of the ninth embodiment is the magnetic field application type single crystal pulling apparatus 900 including the cold storage type cryogenic refrigerator 400 of the fourth embodiment.

The magnetic field application type single crystal pulling apparatus 900 includes a single crystal pulling unit 901 having a raw material melting crucible, a heater, a single crystal pulling mechanism, and the like, a superconducting coil 902 that applies a static magnetic field to the raw material melt, a lifting mechanism 903 of the single crystal pulling unit 901, a current lead 905, a heat shield plate 906, and a helium container 907. A cold storage type cryogenic refrigerator 400 is used for cooling the superconducting coil 902.

According to the ninth embodiment, the magnetic field application type single crystal pulling apparatus having excellent characteristics can be realized by using the refrigerator having excellent characteristics.

(Tenth Embodiment)

A helium re-condensing device of a tenth embodiment includes the refrigerator of the fourth embodiment. Hereinafter, description of contents overlapping with the fourth embodiment will be partially omitted.

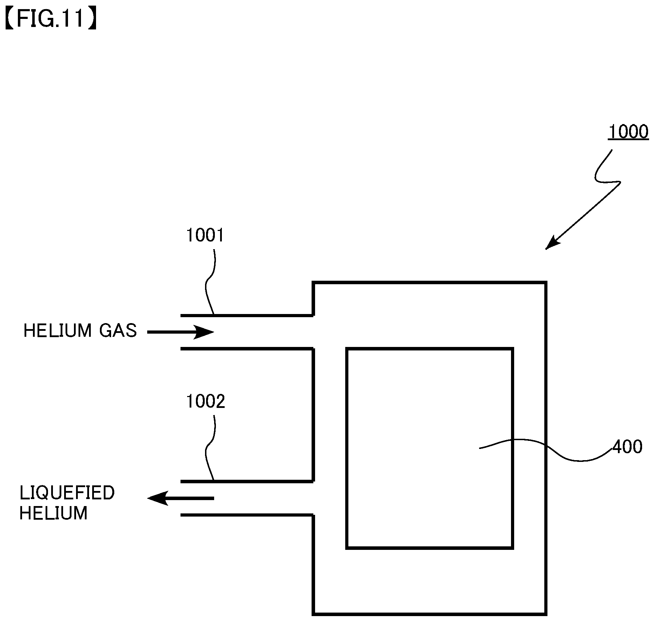

FIG. 11 is a schematic diagram illustrating a schematic configuration of the helium re-condensing device according to the tenth embodiment. The helium re-condensing device of the tenth embodiment is a helium re-condensing device 1000 including the cold storage type cryogenic refrigerator 400 of the fourth embodiment.

The helium re-condensing device 1000 includes the cold storage type cryogenic refrigerator 400, an evaporation pipe 1001, and a liquefaction pipe 1002.

The helium re-condensing device 1000 can recondense helium gas into liquid helium which is evaporated from a device using liquid helium or a liquid helium device. The device using liquid helium may be a superconducting magnet, an nuclear magnetic resonance (NMR) device, a nuclear magnetic resonance imaging (MRI) device, or a physical property measurement system (PPMS). The liquid helium device may be included in a device using a superconducting magnet such as a magnetic property measurement system or the like.

Helium gas is introduced from a liquid helium device (not illustrated) into the helium re-condensing device 1000 through the evaporation pipe 1001. The helium gas is cooled to 4 K equal to or lower than the liquefaction temperature of helium by the cold storage type cryogenic refrigerator 400. The condensed and liquefied liquid helium passes through the liquefaction pipe 1002 and returns to the liquid helium device.

According to the tenth embodiment, a helium re-condensing device having excellent characteristics can be realized by using the refrigerator having excellent characteristics.

(Eleventh Embodiment)

The dilution refrigerator of an eleventh embodiment includes the refrigerator of the fourth embodiment. Hereinafter, description of contents overlapping with the fourth embodiment will be partially omitted.

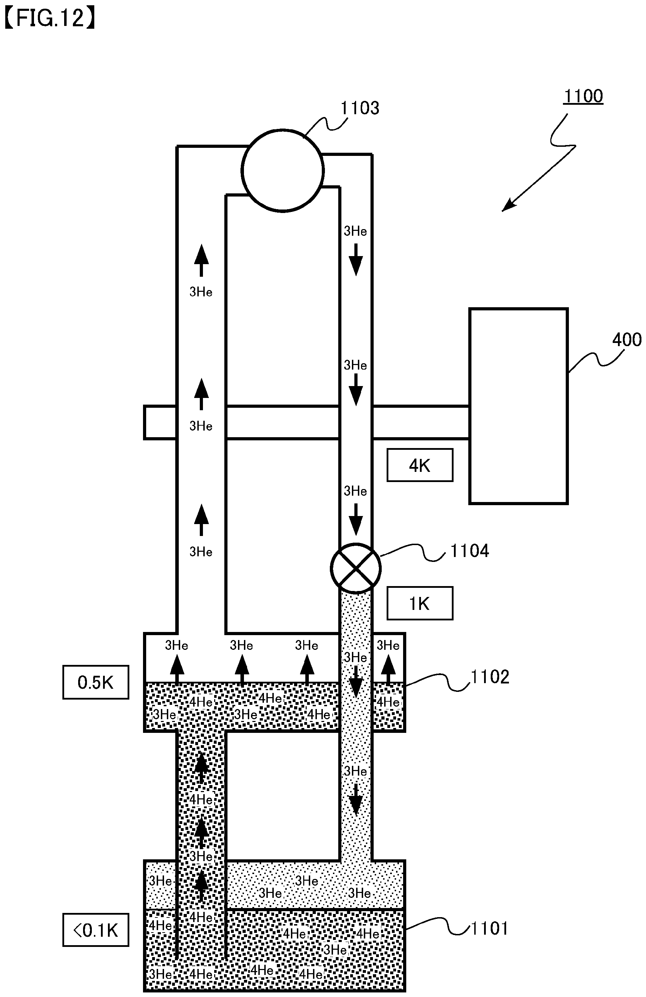

FIG. 12 is a schematic diagram illustrating a schematic configuration of the dilution refrigerator according to the eleventh embodiment. The dilution refrigerator of the eleventh embodiment is the dilution refrigerator 1100 including the cold storage type cryogenic refrigerator 400 of the fourth embodiment.

The dilution refrigerator 1100 includes a mixing chamber 1101, a distillation chamber 1102, a circulation pump 1103, a Joule-Thomson valve 1104, and the cold storage type cryogenic refrigerator 400.

Helium has two isotopes, this is, normal helium 4 (4He) having an atomic weight of 4 and light helium 3 (3He) having an atomic weight of 3. The dilution refrigerator 1100 can realize, for example, a cryogenic temperature of less than 0.1 K by using dilution heat when mixing helium 4 and helium 3.

A mixed liquid of liquid helium 4 and liquid helium 3 exists in the mixing chamber 1101. In the mixing chamber 1101, there is an interface between the phase-separated liquid helium 4 and liquid helium 3. The mixing chamber 1101 has the lowest temperature. The temperature of the mixing chamber is, for example, less than 0.1 K.

The distillation chamber 1102 is connected to the mixing chamber 1101. The distillation chamber 1102 is maintained at, for example, 0.5 K. In the distillation chamber 1102, only helium 3 selectively evaporates and becomes gas.

The circulation pump 1103 has a function of circulating helium 3 as gas.

The cold storage type cryogenic refrigerator 400 has a function of cooling helium 3 that has turned into a gas to, for example, 4 K.

The Joule-Thomson valve 1104 has a function of liquefying helium 3 cooled to 4 K, for example.

The dilution refrigerator 1100 can realize, for example, a cryogenic temperature of less than 0.1 K by forcibly dissolving the liquid helium 3 in the liquid helium 4 in the mixing chamber 1101.

According to the eleventh embodiment, a dilution refrigerator having excellent characteristics can be realized by using a refrigerator having excellent characteristics.

Examples

Hereinafter, examples, comparative examples, and evaluation results thereof of the cold storage material of the first embodiment and the cold storage material particle of the second embodiment will be described.

(Example 1)

$Gd_2O_3$ powder, $Al_2O_3$ powder, and $CaCO_3$ powder were mixed and pulverized in a ball mill for 24 hours to prepare a raw material mixture. The $Al_2O_3$ powder used had a specific surface area of about 4 $m^2$/g. Next, the obtained raw material mixture was dried and then granulated using a tumbling granulator to prepare granulated particles having a particle diameter of 0.3 to 0.5 mm. The obtained raw material mixture was molded to obtain a molded body.

A heat treatment was performed at 500°C for 4 hours in an atmosphere containing hydrogen sulfide ($H_2S$) to sulfurize the molded body and the particles. Heat treatment was performed at 1350°C for 12 hours in an inert gas pressurized atmosphere to sinter the molded body and the particles.

The main constituent elements of the cold storage material and the cold storage material particle of Example 1 are gadolinium oxysulfide. The sub-phase contains a garnet-type rare earth oxide and alumina. The ratio of the X-ray diffraction peak intensity of the garnet-type rare earth oxide to the X-ray diffraction peak intensity of the rare earth oxysulfide was 4%. The concentration of calcium in the cold storage material of Example 1 and the cold storage material particles is 0.055 atom%.

In order to evaluate the reliability when the cold storage material particle according to Example 1 filled the cold storage device and the refrigerator was operated, a cylindrical container having a diameter of 15 mm and a height of 5 mm was filled with the cold storage material particle according to Example 1 at room temperature, and a vibration with simple harmonic oscillation having an amplitude of 2 mm and a maximum acceleration of 400 m/s$^2$ was applied $2 \times 10^9$ times in a state where the container was cooled to a cryogenic temperature. The weight ratio of the cold storage material particles destroyed after the vibration test was 0.014%.

In the following Examples and Comparative Examples, the mixing time of the raw material powders, the conditions of the sulfurization heat treatment, the conditions of the sintering heat treatment, and the like are adjusted to be appropriate conditions. In addition, the test conditions of the refrigerator were set to be the same.

(Example 2)

A cold storage material and cold storage material particles were produced in the same manner as in Example 1 except that an $MgCO_3$ powder was used instead of the $CaCO_3$ powder.

(Example 3)

A cold storage material and cold storage material particles were produced in the same manner as in Example 1 except that a $SrCO_3$ powder was used instead of the $CaCO_3$ powder.

(Example 4)

A cold storage material and cold storage material particles were produced in the same manner as in Example 1 except that a $BaCO_3$ powder was used instead of the $CaCO_3$ powder.

(Example 5)

A cold storage material and cold storage material particles were produced in the same manner as in Example 1 except that a $Tb_2O_3$ powder was used instead of the $Gd_2O_3$ powder.

(Example 6)

A cold storage material and cold storage material particles were produced in the same manner as in Example 1 except that a $Dy_2O_3$ powder was used instead of the $Gd_2O_3$ powder.

(Example 7)

A cold storage material and cold storage material particles were produced in the same manner as in Example 2 except that a $Ho_2O_3$ powder was used instead of the $Gd_2O_3$ powder.

(Example 8)

A cold storage material and cold storage material particles were produced in the same manner as in Example 1 except that an $MgCO_3$ powder was used in addition to the $CaCO_3$ powder.

(Example 9)

A cold storage material and cold storage material particles were produced in the same manner as in Example 1 except that a $SrCO_3$ powder was used in addition to a $CaCO_3$ powder.

(Examples 10 to 14)

A cold storage material and cold storage material particles were produced in the same manner as in Example 1 except that the weight of the $CaCO_3$ powder was changed.

(Examples 15 to 17)

A cold storage material and cold storage material particles were produced in the same manner as in Example 1 except that a part of the $Gd_2O_3$ powder was changed to $Tb_2O_3$, $Dy_2O_3$, or $Ho_2O_3$.

(Examples 18 to 21)

A cold storage material and cold storage material particles were produced in the same manner as in Example 1 except that the specific surface area and amount of the $Al_2O_3$ powder were changed.

(Example 22)

The $Gd_2O_3$ powder and the $Al_2O_3$ powder were added to a sodium alginate aqueous solution and mixed for 12 hours to prepare a slurry. The prepared slurry was added dropwise to a calcium lactate aqueous solution as a gelling solution. A syringe was used for dropping the slurry. The diameter of the outlet port of the syringe was 510 um, and the distance from the tip of the syringe to the liquid level of the calcium lactate aqueous solution was 100 mm.
A mold was filled with the slurry, and then, the slurry was immersed in a gelling solution.
The slurry dropped by the syringe and the slurry filling the mold were held in the gelling solution for 5 hours.
Thereafter, the gelled granulated particles were cleaned with pure water. The slurry filling the mold was removed from the mold and then cleaned with pure water to obtain a molded body. After cleaning the molded body and the particles, the molded body and the particles were dried. After the molded body and the particles were dried, the molded body and the particles were degreased, sulfurized, and sintered.
Degreasing was performed at 600°C for 6 hours under an air atmosphere. After the degreasing, heat treatment was performed at 500°C for 4 hours in an atmosphere containing hydrogen sulfide ($H_2S$) to sulfurize the molded body and the particles. Heat treatment was performed at 1350°C for 12 hours in an inert gas pressurized atmosphere to sinter the molded body and the particles.

(Example 23)

A cold storage material and cold storage material particles were produced in the same manner as in Example 22 except that a magnesium chloride aqueous solution was used instead of the calcium lactate aqueous solution.

(Example 24)

A cold storage material and cold storage material particles were produced in the same manner as in Example 22 except that a strontium chloride aqueous solution was used instead of the calcium lactate aqueous solution.

(Example 25)

A cold storage material and cold storage material particles were produced in the same manner as in Example 22 except that a barium chloride aqueous solution was used instead of the calcium lactate aqueous solution.

(Example 26)

Cold storage material particles were produced in the same manner as in Example 22 except that an air pulse dispenser was used instead of a syringe as a method of dropping a slurry. The diameter of the nozzle was 510 um, and the distance from the tip of the nozzle to the liquid level of the calcium lactate aqueous solution was 100 mm.

(Example 27)

Cold storage material particles were produced in the same manner as in Example 22 except that a piezo dispenser was used instead of a syringe as a method of dropping a slurry. The diameter of the nozzle was 510 um, and the distance from the tip of the nozzle to the liquid level of the calcium lactate aqueous solution was 100 mm.

(Example 28)

A cold storage material particle was produced in the same manner as in Example 22 except that a continuous type inkjet was used instead of a syringe as a method of dropping a slurry. The diameter of the nozzle was 510 um, and the distance from the tip of the nozzle to the liquid level of the calcium lactate aqueous solution was 100 mm.

(Examples 29 to 34)

The cold storage material particle of Examples 29 to 34 is different from the cold storage material particle of Example 26 in the particle diameter or aspect ratio of the cold storage material particle. When the cold storage material particle of Examples 29 to 34 was produced, the diameter of the nozzle and the distance from the tip of the nozzle to the surface of the gelling solution were changed as compared with the case of producing the cold storage material particle of Example 26.

(Example 35)

The cold storage material particle of Example 35 is different from the cold storage material particle of Example 26 in containing perovskite-type $GdAlO_3$ in addition to gadolinium oxysulfide, garnet-type rare earth oxide, and alumina. When the cold storage material particle of Example 35 was produced, the firing temperature was changed to 1300°C as compared with the case of producing the cold storage material particle of Example 26.

(Comparative Example 1)

The cold storage material and the cold storage material particle of Comparative Example 1 are different from the cold storage material and the cold storage material particle of Example 1 in that the X-ray diffraction peak intensity ratio of the garnet-type rare earth oxide to the rare earth oxysulfide is as small as 0.08%. When the cold storage material and the cold storage material particle of Comparative Example 1 were produced, the weight of the alumina powder was reduced as compared with the case of producing the cold storage material and the cold storage material particle of Example 1.

(Comparative Example 2)

The cold storage material and the cold storage material particle of Comparative Example 2 are different from the cold storage material and the cold storage material particle of Example 1 in that the ratio of the X-ray diffraction peak intensity of the garnet-type rare earth oxide to the X-ray diffraction peak intensity of the rare earth oxysulfide is as large as 41%. When the cold storage material and the cold storage material particle of Comparative Example 2 were produced, the weight of the alumina powder was increased as compared with the case of producing the cold storage material and the cold storage material particle of Example 1.

(Comparative Example 3)

The cold storage material and the cold storage material particle of Comparative Example 3 are different from the cold storage material and the cold storage material particle of Example 1 in that the atomic concentration of calcium is as low as 0.0008 atom%. When the cold storage material and the cold storage material particle of Comparative Example 3 were produced, the weight of the $CaCO_3$ powder was reduced as compared with the case of producing the cold storage material particle of Example 1.

(Comparative Example 4)

The cold storage material and the cold storage material particle of Comparative Example 4 are different from the cold storage material and the cold storage material particle of Example 4 in that the atomic concentration of calcium is as high as 15 atom%. When the cold storage material and the cold storage material particle of Comparative Example 4 were produced, the weight of the $CaCO_3$ powder was increased as compared with the case of producing the cold storage material and the cold storage material particle of Example 1.

(Comparative Example 5)

The cold storage material and the cold storage material particle of Comparative Example 5 are different from the cold storage material and the cold storage material particle of Example 1 in that they do not contain a garnet-type rare earth oxide. When the cold storage material and the cold storage material particle of Comparative Example 5 were produced, an alumina powder having a specific surface area of 150 $m^2$/g was used, and the firing temperature was 1250°C, as compared with the case of producing the cold storage material and the cold storage material particle of Example 1. The constituent phases are gadolinium oxysulfide, alumina, and perovskite-type $GdAlO_3$.

The ratio of the X-ray diffraction peak intensity of the garnet-type rare earth oxide to the X-ray diffraction peak intensity of the rare earth oxysulfide, the particle diameter, the aspect ratio, the maximum value of the volume specific heat, the result of the vibration test, and the change ratio of the refrigerator performance before and after the vibration test in the cold storage material and the cold storage material particle according to each of Examples and Comparative Examples are shown in Table 1. A molded body was used for measuring the maximum value of the volume specific heat, and cold storage material particles were used for measuring other items.

In the evaluation of the refrigeration performance, the cold storage material particle of 250 g filled the low-temperature side of the second-stage cold storage device of the two-stage GM refrigerator illustrated in FIG. 5, while the Pb cold storage material of 250 g filled the high-temperature side, a refrigerator was assembled, a refrigeration test was performed, and the refrigeration capacity at 4.2 K was measured. In a first-stage cold storage device, a thermal load was applied so that the temperature was 50 K.

The reliability of the refrigerator can be evaluated by checking the ratio of the refrigeration performance before and after the vibration test. The lower the reduction rate of the refrigeration performance before and after the vibration test, the higher the reliability of the refrigerator.

[Table 1]

| | Granulation method | Phase of oxysulfide | Sub-phase | Type of Group 2 element | Concentration of Group 2 element in particle (atom%) | X-ray diffraction peak intensity ratio of garnet-type oxide to rare earth oxysulfide | Particle diameter of cold storage material particle (μm) | Aspect ratio of cold storage material particle | Maximum value of volume specific heat at 10K or less (J/cm$^3$•K) | Weight ratio of particles destroyed after vibration test at cryogenic temperature (wt%) | Ratio of refrigeration capacity before and after vibration test | Refrigeration capacity at 4.2K (W) |
|---|---|---|---|---|---|---|---|---|---|---|---|---|
| Example 1 | Tumbling granulation | Gd2O2S | Garnet phase, alumina | Ca | 0.055% | 4.0% | 250 | 1 | 0.80 | 0.014 | 99.9% | - |
| Example 2 | Tumbling granulation | Gd2O2S | Garnet phase, alumina | Mg | 0.067% | 4.6% | 400 | 1 | 0.80 | 0.014 | 99.9% | - |
| Example 3 | Tumbling granulation | Gd2O2S | Garnet phase, alumina | Sr | 0.023% | 3.0% | 260 | 1 | 0.80 | 0.015 | 99.9% | - |
| Example 4 | Tumbling granulation | Gd2O2S | Garnet phase, alumina | Ba | 0.079% | 4.1% | 440 | 1.1 | 0.80 | 0.014 | 99.9% | - |
| Example 5 | Tumbling granulation | Tb2O2S | Garnet phase, alumina | Ca | 0.050% | 4.0% | 220 | 1.2 | 1.05 | 0.014 | 99.9% | - |
| Example 6 | Tumbling granulation | Dy2O2S | Garnet phase, alumina | Ca | 0.050% | 4.0% | 242 | 1.1 | 1.02 | 0.014 | 99.9% | - |
| Example 7 | Tumbling granulation | Ho2O2S | Garnet phase, alumina | Mg | 0.050% | 4.0% | 360 | 1 | 1.26 | 0.014 | 99.9% | - |
| Example 8 | Tumbling granulation | Gd2O2S | Garnet phase, alumina | Ca | 0.055% | 5.1% | 460 | 1.5 | 0.80 | 0.012 | 99.9% | - |
| | | | | Mg | 0.060% | | | | | | | |

| | Granulation method | Phase of oxysulfide | Sub-phase | Type of Group 2 element | Concentration of Group 2 element in particle (atom%) | X-ray diffraction peak intensity ratio of garnet-type oxide to rare earth oxysulfide | Particle diameter of cold storage material particle ($\mu$m) | Aspect ratio of cold storage material particle | Maximum value of volume specific heat at 10K or less (J/cm$^3$·K) | Weight ratio of particles destroyed after vibration test at cryogenic temperature (wt%) | Ratio of refrigeration capacity before and after vibration test | Refrigeration capacity at 4.2K (W) |
|---|---|---|---|---|---|---|---|---|---|---|---|---|
| Example 9 | Tumbling granulation | Gd2O2S | Garnet phase, alumina | Ca | 0.055% | 5.1% | 300 | 1.3 | 0.80 | 0.012 | 99.9% | - |
| | | | | Sr | 0.040% | | | | | | | |
| Example 10 | Tumbling granulation | Gd2O2S | Garnet phase, alumina | Ca | 0.001% | 3.8% | 250 | 1.1 | 0.80 | 0.015 | 99.9% | - |
| Example 11 | Tumbling granulation | Gd2O2S | Garnet phase, alumina | Ca | 0.120% | 5.0% | 250 | 1.1 | 0.80 | 0.012 | 99.9% | - |
| Example 12 | Tumbling granulation | Gd2O2S | Garnet phase, alumina | Ca | 1.000% | 5.5% | 250 | 1.1 | 0.75 | 0.012 | 99.9% | - |
| Example 13 | Tumbling granulation | Gd2O2S | Garnet phase, alumina | Ca | 4.900% | 5.7% | 250 | 1.1 | 0.70 | 0.012 | 99.9% | - |
| Example 14 | Tumbling granulation | Gd2O2S | Garnet phase, alumina | Ca | 9.900% | 6.1% | 250 | 1.1 | 0.60 | 0.012 | 99.9% | - |
| Example 15 | Tumbling granulation | (Gd, Tb)2O2S | Garnet phase, alumina | Ca | 0.050% | 4.0% | 1000 | 1.6 | 0.78 | 0.014 | 99.9% | - |
| Example 16 | Tumbling granulation | (Gd, Dy)2O2S | Garnet phase, alumina | Ca | 0.050% | 4.0% | 50 | 1.1 | 0.66 | 0.014 | 99.9% | - |

EP 4 471 356 A1

| | Granulation method | Phase of oxysulfide | Sub-phase | Type of Group 2 element | Concentration of Group 2 element in particle (atom%) | X-ray diffraction peak intensity ratio of garnet-type oxide to rare earth oxysulfide | Particle diameter of cold storage material particle (μm) | Aspect ratio of cold storage material particle | Maximum value of volume specific heat at 10K or less (J/cm$^3$·K) | Weight ratio of particles destroyed after vibration test at cryogenic temperature (wt%) | Ratio of refrigeration capacity before and after vibration test | Refrigeration capacity at 4.2K (W) |
|---|---|---|---|---|---|---|---|---|---|---|---|---|
| Example 17 | Tumbling granulation | (Gd. Ho) 202S | Garnet phase, alumina | Ca | 0.050% | 4.0% | 450 | 1 | 0.66 | 0.014 | 99.9% | - |
| Example 18 | Tumbling granulation | Gd202S | Garnet phase, alumina | Ca | 0.055% | 0.2% | 352 | 1 | 0.90 | 0.100 | 99.9% | - |
| Example 19 | Tumbling granulation | Gd202S | Garnet phase, alumina | Ca | 0.055% | 1.0% | 251 | 1 | 0.85 | 0.050 | 96% | - |
| Example 20 | Tumbling granulation | Gd202S | Garnet phase, alumina | Ca | 0.055% | 20.0% | 250 | 1 | 0.55 | 0.010 | 99.9% | - |
| Example 21 | Tumbling granulation | Gd202S | Garnet phase, alumina | Ca | 0.055% | 39.0% | 240 | 1 | 0.51 | 0.008 | 100% | - |
| Example 22 | Syringe dripping | Gd202S | Garnet phase, alumina | Ca | 0.055% | 4.0% | 260 | 1 | 0.80 | 0.014 | 99.9% | - |
| Example 23 | Syringe dripping | Gd202S | Garnet phase, alumina | Mg | 0.067% | 4.6% | 250 | 1 | 0.80 | 0.014 | 99.9% | - |
| Example 24 | Syringe dripping | Gd202S | Garnet phase, alumina | Sr | 0.023% | 3.0% | 243 | 1 | 0.80 | 0.015 | 99.9% | - |

(continued)

| | Granulation method | Phase of oxysulfide | Sub-phase | Type of Group 2 element | Concentration of Group 2 element in particle (atom%) | X-ray diffraction peak intensity ratio of garnet-type oxide to rare earth oxysulfide | Particle diameter of cold storage material particle (μm) | Aspect ratio of cold storage material particle | Maximum value of volume specific heat at 10K or less (J/cm³·K) | Weight ratio of particles destroyed after vibration test at cryogenic temperature (wt%) | Ratio of refrigeration capacity before and after vibration test | Refrigeration capacity at 4.2K (W) |
|---|---|---|---|---|---|---|---|---|---|---|---|---|
| Example 25 | Syringe dripping | Gd2O2S | Garnet phase, alumina | Ba | 0.003% | 4.1% | 440 | 1.1 | 0.80 | 0.014 | 99.9% | - |
| Example 26 | Air pulse dispenser | Gd2O2S | Garnet phase, alumina | Ca | 0.055% | 4.0% | 430 | 1.1 | 0.80 | 0.014 | 99.9% | - |
| Example 27 | Piezo dispenser | Gd2O2S | Garnet phase, alumina | Ca | 0.055% | 4.0% | 420 | 1.1 | 0.80 | 0.014 | 99.9% | - |
| Example 28 | Continuous type inkjet | Gd2O2S | Garnet phase, alumina | Ca | 0.055% | 4.0% | 250 | 1.1 | 0.80 | 0.014 | 99.9% | - |
| Example 29 | Air pulse dispenser | Gd2O2S | Garnet phase, alumina | Ca | 0.055% | 4.0% | 50 | 1 | 0.80 | 0.014 | 99.9% | 0.80 |
| Example 30 | Air pulse dispenser | Gd2O2S | Garnet phase, alumina | Ca | 0.055% | 4.0% | 3000 | 1 | 0.80 | 0.014 | 99.9% | 0.78 |
| Example 31 | Air pulse dispenser | Gd2O2S | Garnet phase, alumina | Ca | 0.055% | 4.0% | 40 | 1 | 0.80 | 0.014 | 99.9% | 0.58 |
| Example 32 | Air pulse dispenser | Gd2O2S | Garnet phase, alumina | Ca | 0.055% | 4.0% | 4000 | 1 | 0.80 | 0.014 | 99.9% | 0.60 |

(continued)

| | Granulation method | Phase of oxysulfide | Sub-phase | Type of Group 2 element | Concentration of Group 2 element in particle (atom%) | X-ray diffraction peak intensity ratio of garnet-type oxide to rare earth oxysulfide | Particle diameter of cold storage material particle (μm) | Aspect ratio of cold storage material particle | Maximum value of volume specific heat at 10K or less (J/cm³·K) | Weight ratio of particles destroyed after vibration test at cryogenic temperature (wt%) | Ratio of refrigeration capacity before and after vibration test | Refrigeration capacity at 4.2K (W) |
|---|---|---|---|---|---|---|---|---|---|---|---|---|
| Example 33 | Air pulse dispenser | Gd2O2S | Garnet phase, alumina | Ca | 0.055% | 4.0% | 250 | 4.8 | 0.80 | 0.014 | 99.9% | 0.75 |
| Example 34 | Air pulse dispenser | Gd2O2S | Garnet phase, alumina | Ca | 0.055% | 4.0% | 250 | 5.5 | 0.80 | 0.014 | 99.9% | 0.59 |
| Example 35 | Air pulse dispenser | Gd2O2S | Garnet phase, alumina, perovskite-type GdAlO3 | Ca | 0.055% | 4.0% | 430 | 1.1 | 0.75 | 0.014 | 99.9% | - |
| Comparative Example 1 | Tumbling granulation | Gd2O2S | Garnet phase, alumina | Ca | 0.055% | 0.08% | 250 | 1.1 | 1.00 | 1.20 | 81% | - |
| Comparative Example 2 | Tumbling granulation | Gd2O2S | Garnet phase, alumina | Ca | 0.055% | 41.00% | 250 | 1.1 | 0.40 | 0.005 | 99.9% | - |
| Comparative Example 3 | Tumbling granulation | Gd2O2S | Garnet phase, alumina | Ca | 0.0008% | 0.09% | 250 | 1.1 | 1.00 | 1.100 | 80% | - |
| Comparative Example 4 | Tumbling granulation | Gd2O2S | Garnet phase, alumina | Ca | 15.000% | 4.00% | 250 | 1.1 | 0.45 | 0.014 | 99.9% | - |

| | Granulation method | Phase of oxysulfide | Sub-phase | Type of Group 2 element | Concentration of Group 2 element in particle (atom%) | X-ray diffraction peak intensity ratio of garnet-type oxide to rare earth oxysulfide | Particle diameter of cold storage material particle ($\mu$m) | Aspect ratio of cold storage material particle | Maximum value of volume specific heat at 10K or less (J/cm$^3$•K) | Weight ratio of particles destroyed after vibration test at cryogenic temperature (wt%) | Ratio of refrigeration capacity before and after vibration test | Refrigeration capacity at 4.2K (W) |
|---|---|---|---|---|---|---|---|---|---|---|---|---|
| Comparative Example 5 | Tumbling granulation | Gd202S | Alumina, perovskite-type GdAlO3 | Ca | 0.055% | 0.00% | 250 | 1.1 | 0.80 | 5.00 | 60% | - |

From the results of Comparative Example 1 and Examples 18 to 21, it is found that when the ratio of the X-ray diffraction peak intensity of the garnet-type rare earth oxide to the X-ray diffraction peak intensity of the rare earth oxysulfide in the cold storage material is less than 1%, the intensity remarkably decreases, and the reliability of the refrigerator also decreases. This is considered to be because the abundance ratio of the garnet-type rare earth oxide in the cold storage material decreases.

From the results of Comparative Example 2 and Examples 18 to 21, it is found that when the ratio of the X-ray diffraction peak intensity of the garnet-type rare earth oxide to the X-ray diffraction peak intensity of the rare earth oxysulfide in the cold storage material is more than 40%, the specific heat is as low as 0.4 J/K·cc. This is considered to be because the relative amount of the rare earth oxysulfide in the cold storage material decreases.

From the results of Comparative Example 3 and Examples 10 to 14, it is found that when the atomic concentration of the Group 2 element in the cold storage material is 0.001 atom% or more, the production ratio of the garnet-type rare earth oxide increases, and the strength is improved, thereby increasing the reliability of the refrigerator.

From the results of Comparative Example 4 and Examples 10 to 14, when the atomic concentration of the Group 2 element in the cold storage material is more than 10 atom%, the volume specific heat is as low as 0.4 J/(cm$^3$·K), and the refrigeration capacity of the refrigerator using the cold storage material particles is significantly deteriorated. This is considered to be because the proportion of the rare earth element relatively decreases as the proportion of the Group 2 element in the cold storage material particles increases.

From the results of Comparative Example 5 and Example 1, it is found that when the specific surface area of the alumina powder exceeds 120 m$^2$/g, a garnet-type rare earth oxide is not produced even if calcium is contained. Therefore, it is found that the strength per grain is also smaller than that in Example 1.

The result of Example 35 shows that a perovskite-type rare earth oxide may be present in the cold storage material and the cold storage material particle. In addition, since the perovskite-type rare earth oxide has a specific heat peak at a slightly lower temperature than that of the rare earth oxysulfide, specific heat characteristics at a low temperature are improved.

Table 1 shows that when the particle diameter of the cold storage material particle falls within the range of 50 um or more and 3000 $\mu$m or less, the refrigeration capacity at 4.2 K is remarkably improved.

Table 1 shows that when the aspect ratio of the cold storage material particle is 5 or less, the refrigeration capacity at 4.2 K is remarkably improved.

From Table 1, it is found that even when the method of granulating the cold storage material particles is different, the equivalent particle diameter, aspect ratio, content of the garnet phase, and content of the Group 2 element are shown by appropriately adjusting the synthesis conditions.

From Table 1, it can be seen that even in the case of the cold storage material particles having different granulation methods, the performance and reliability of the refrigerator equipped with the cold storage material particles are equivalent as long as the particle diameter, the aspect ratio, and the specific heat are equivalent.

From the above Examples, the effect exhibited by the cold storage material particle of the first embodiment was confirmed.

Although the case of an air pulse dispenser or a piezo dispenser has been described as an example of the dispenser, a plunger dispenser may be used.

The case of the continuous type inkjet has been described as an example of the inkjet, but an on-demand type inkjet may be used.

While certain embodiments have been described, these embodiments have been presented by way of example only, and are not intended to limit the scope of the inventions. These embodiments may be embodied in a variety of other forms; furthermore, various omissions, substitutions and changes may be made without departing from the spirit of the inventions. For example, a component of one embodiment may be replaced or changed with a component of another embodiment. These embodiments and modifications thereof are included in the scope and gist of the invention, and are included in the invention described in the claims and the equivalent scope thereof.

**Claims**

1. A cold storage material comprising:

   a rare earth oxysulfide containing at least one rare earth element selected from the group consisting of Y, La, Ce, Pr, Nd, Sm, Eu, Gd, Tb, Dy, Ho, Er, Tm, Yb, and Lu;
   a garnet-type rare earth oxide containing Al and at least one rare earth element selected from the group consisting of Y, La, Ce, Pr, Nd, Sm, Eu, Gd, Tb, Dy, Ho, Er, Tm, Yb, and Lu; and
   an aluminum oxide,
   wherein a ratio of X-ray diffraction peak intensity of the garnet-type rare earth oxide to X-ray diffraction peak intensity of the rare earth oxysulfide is 0.1% or more and 40% or less.

2. The cold storage material according to claim 1, further comprising 0.001 atom% or more and 10 atom% or less of a Group 2 element.

3. The cold storage material according to claim 2, wherein the Group 2 element is at least one element selected from the group consisting of Mg, Ca, Sr, and Ba.

4. The cold storage material according to any one of claims 1 to 3, further comprising a perovskite-type rare earth oxide.

5. A cold storage material particle formed of the cold storage material according to any one of claims 1 to 4 and having a particle diameter of 50 um or more and 3 mm or less.

6. The cold storage material particle according to claim 5, wherein an aspect ratio is 1 or more and 5 or less.

7. A granulated particle serving as a raw material of the cold storage material particle according to claim 5 or 6, wherein an aspect ratio is 1 or more and 5 or less.

8. A cold storage device comprising the cold storage material according to any one of claims 1 to 4.

9. A cold storage device filled with a plurality of the cold storage material particles according to claim 5 or 6.

10. The cold storage device according to claim 9, wherein a ratio of the cold storage material particles having a circularity R of 0.5 or less represented by $4\pi A/L^2$ is 50 or less, where L is a perimeter of a projection image of the plurality of filling cold storage material particles, and A is an actual area of the projection image.

11. A refrigerator comprising the cold storage device according to any one of claims 8 to 10.

12. A cryopump comprising the refrigerator according to claim 11.

13. A superconducting magnet comprising the refrigerator according to claim 11.

14. A nuclear magnetic resonance imaging apparatus comprising the refrigerator according to claim 11.

15. A nuclear magnetic resonance apparatus comprising the refrigerator according to claim 11.

16. A magnetic field application type single crystal pulling apparatus comprising the refrigerator according to claim 11.

17. A helium re-condensing device comprising the refrigerator according to claim 11.

18. A dilution refrigerator comprising the refrigerator according to claim 11.

【FIG.1】

【FIG.2】

【FIG.3】

【FIG.4】

【FIG.5】

【FIG.6】

【FIG.7】

【FIG.8】

【FIG.9】

【FIG.10】

【FIG.11】

1000

1001

HELIUM GAS →

1002

LIQUEFIED
HELIUM ←

400

【FIG.12】

## INTERNATIONAL SEARCH REPORT

| | International application No. |
|---|---|
| | **PCT/JP2023/002098** |

**A. CLASSIFICATION OF SUBJECT MATTER**

*F25B 9/00*(2006.01)i; *C09K 5/14*(2006.01)i
FI:   C09K5/14 F; F25B9/00 D

According to International Patent Classification (IPC) or to both national classification and IPC

**B. FIELDS SEARCHED**

Minimum documentation searched (classification system followed by classification symbols)

F25B9/00; C09K5/14

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2005-336240 A (KONOSHIMA CHEMICAL CO LTD) 08 December 2005 (2005-12-08) entire text, all drawings | 1-18 |
| A | WO 2018/025581 A1 (KONOSHIMA CHEMICAL CO LTD) 08 February 2018 (2018-02-08) entire text, all drawings | 1-18 |
| A | JP 2021-120345 A (TOSHIBA CORP) 19 August 2021 (2021-08-19) entire text, all drawings | 1-18 |
| A | JP 2004-189906 A (TOSHIBA CORP) 08 July 2004 (2004-07-08) entire text, all drawings | 1-18 |
| A | JP 2001-354474 A (KONOSHIMA CHEMICAL CO LTD) 25 December 2001 (2001-12-25) entire text, all drawings | 1-18 |

☐ Further documents are listed in the continuation of Box C.    ☑ See patent family annex.

| | |
|---|---|
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **27 February 2023** | **14 March 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/002098**

| Patent document cited in search report | | | Publication date (day/month/year) | Patent family member(s) | | | Publication date (day/month/year) |
|---|---|---|---|---|---|---|---|
| JP | 2005-336240 | A | 08 December 2005 | (Family: none) | | | |
| WO | 2018/025581 | A1 | 08 February 2018 | US | 2020/0248058 | A1 | |
| | | | | entire text, all drawings | | | |
| | | | | EP | 3495445 | A1 | |
| | | | | CN | 109312215 | A | |
| | | | | JP | 18-25581 | A1 | |
| JP | 2021-120345 | A | 19 August 2021 | US | 2017/0275176 | A1 | |
| | | | | entire text, all drawings | | | |
| | | | | WO | 2016/047419 | A1 | |
| | | | | EP | 3199608 | A1 | |
| | | | | CN | 106715637 | A | |
| JP | 2004-189906 | A | 08 July 2004 | (Family: none) | | | |
| JP | 2001-354474 | A | 25 December 2001 | (Family: none) | | | |

Form PCT/ISA/210 (patent family annex) (January 2015)

**EP 4 471 356 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003073661 A
- JP 2003213252 A
- WO 2018025581 A